(19) **Europäisches Patentamt / European Patent Office / Office européen des brevets**

(11) **EP 3 987 574 B1**

(12) **FASCICULE DE BREVET EUROPEEN**

(45) Date de publication et mention
de la délivrance du brevet:
**08.11.2023 Bulletin 2023/45**

(21) Numéro de dépôt: **20733630.6**

(22) Date de dépôt: **22.06.2020**

(51) Classification Internationale des Brevets (IPC):
**H01L 27/15** $^{(2006.01)}$   **H01L 33/00** $^{(2010.01)}$
**C30B 25/18** $^{(2006.01)}$

(52) Classification Coopérative des Brevets (CPC):
**H01L 27/156; C30B 25/183; C30B 29/403;**
**H01L 33/007**

(86) Numéro de dépôt international:
**PCT/EP2020/067382**

(87) Numéro de publication internationale:
**WO 2020/254695 (24.12.2020 Gazette 2020/52)**

(54) **PROCÉDÉ DE RÉALISATION DE VIGNETTES DE NITRURE DESTINÉES CHACUNE À FORMER UN DISPOSITIF ÉLECTRONIQUE OU OPTOÉLECTRONIQUE**

VERFAHREN ZUR HERSTELLUNG VON NITRID-KACHELN ZUR HERSTELLUNG EINER ELEKTRONISCHEN ODER OPTOELEKTRONISCHEN VORRICHTUNG

PROCESS FOR PRODUCING NITRIDE TILES EACH INTENDED TO FORM AN ELECTRONIC OR OPTOELECTRONIC DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **21.06.2019 FR 1906756**

(43) Date de publication de la demande:
**27.04.2022 Bulletin 2022/17**

(73) Titulaires:
• **Commissariat à l'Energie Atomique et aux Energies Alternatives**
**75015 Paris (FR)**
• **Centre national de la recherche scientifique**
**75016 Paris (FR)**

(72) Inventeurs:
• **FEUILLET, Guy**
**38054 GRENOBLE Cedex 9 (FR)**
• **ALLOING, Blandine**
**06560 VALBONNE (FR)**
• **BONO, Hubert**
**38054 GRENOBLE Cedex 9 (FR)**
• **DAGHER, Roy**
**38054 GRENOBLE Cedex 9 (FR)**
• **ZUNIGA PEREZ, Jesus**
**06410 BIOT (FR)**
• **CHARLES, Matthew**
**38054 GRENOBLE Cedex 9 (FR)**
• **BUCKLEY, Julien**
**38054 GRENOBLE Cedex 9 (FR)**
• **ESCOFFIER, René**
**38054 GRENOBLE Cedex 9 (FR)**

(74) Mandataire: **Hautier IP**
**20, rue de la Liberté**
**06000 Nice (FR)**

(56) Documents cités:
**US-A1- 2010 109 126**

• **ZUBIA D ET AL: "Nanoheteroepitaxial growth of GaN on Si by organometallic vapor phase epitaxy", APPLIED PHYSICS LETTERS, A I P PUBLISHING LLC, US, vol. 76, no. 7, 14 février 2000 (2000-02-14), pages 858-860, XP012025868, ISSN: 0003-6951, DOI: 10.1063/1.125608**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

**[DOMAINE TECHNIQUE**

L'invention concerne la réalisation de vignettes faites d'un nitrure (N) obtenu de préférence à partir d'au moins l'un parmi le gallium (Ga), l'indium (In) et l'aluminium (Al). L'invention trouve par exemple pour application le domaine des dispositifs optoélectroniques comprenant une pluralité de diodes électroluminescentes (LED) de taille micrométrique, généralement appelées micro-LEDs. Dans ce domaine, une utilisation particulièrement avantageuse de l'invention concerne la réalisation d'écrans de faibles tailles généralement appelées micro-écrans ou encore micro-display.

**ÉTAT DE LA TECHNIQUE**

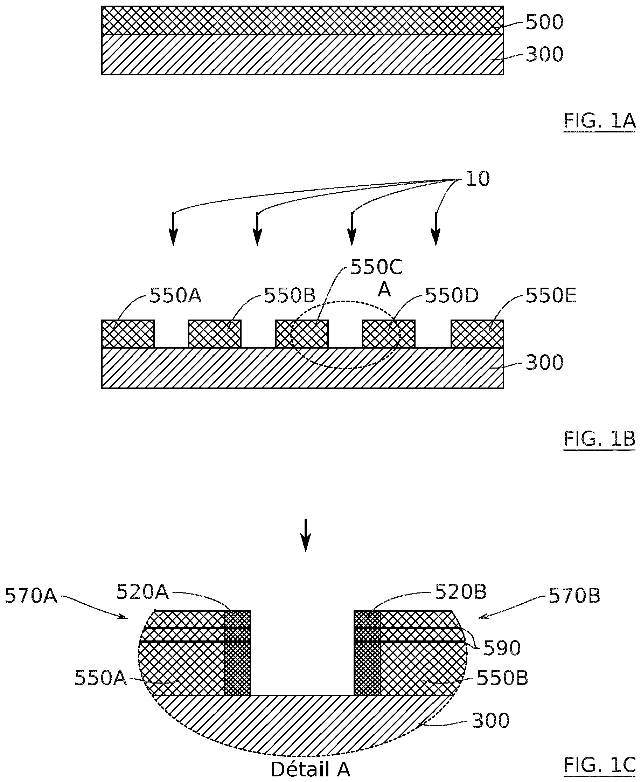

Les dispositifs optoélectroniques à base de micro-LEDs, comprennent un substrat surmonté d'une pluralité de micro-LEDs distantes les unes des autres. Ces dispositifs optoélectroniques sont habituellement formés en effectuant les étapes décrites succinctement ci-dessous et illustrées schématiquement en figures 1A et 1B :

- une première étape consiste à obtenir une couche de nitrure 500, typiquement une couche de nitrure de gallium (GaN). Ce type de nitrure est classiquement obtenu par croissance épitaxiale à partir d'une couche cristalline 300. Cette étape est illustrée en figure 1A.

- une seconde étape consiste à délimiter spatialement des vignettes 550A-550E, également désignées mesas, dans la couche de nitrure 500 épitaxiée pleine plaque sur la couche cristalline 300. Cette délimitation spatiale est par exemple effectuée par une gravure 10 de type RIE (acronyme du vocable anglais reactive-ion etching, signifiant gravure ionique réactive). Chacune de ces vignettes 550A-550E est destinée à former une micro-LED 570A-570D. Pour cela, on peut par exemple réaliser des puits quantiques 590 dans chacune des vignettes 550A-550E afin de former les micro-LEDs 570A-570D.

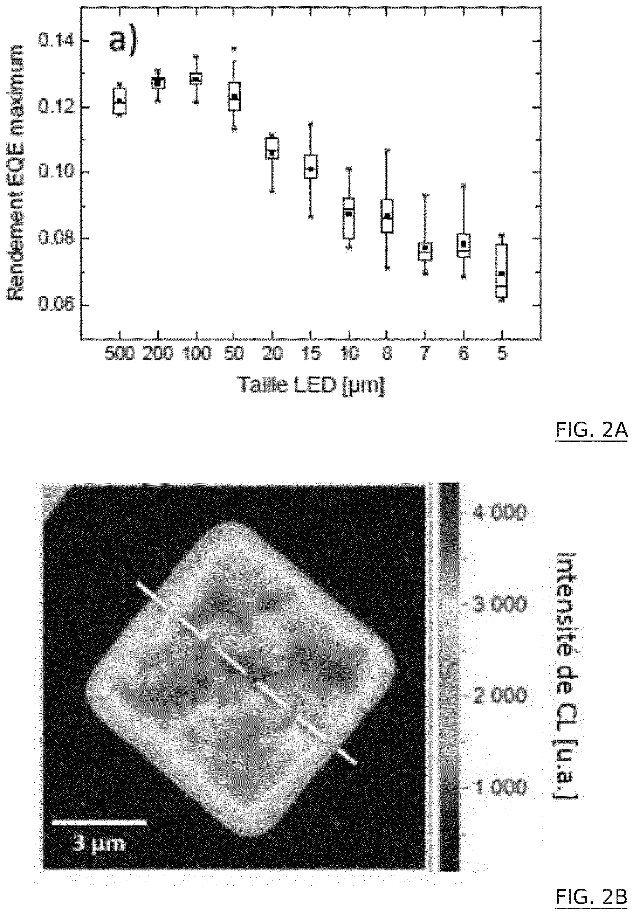

Un inconvénient de ces dispositifs optoélectroniques est que le rendement quantique externe de ces micro-LED dépend étroitement de leur taille. Ceci est clairement représenté dans le graphe de la figure 2A. Sur ce graphe, on voit clairement que lorsque la taille de la micro-LED diminue, le rendement quantique externe diminue également. Cette diminution de rendement est particulièrement significative pour des micro-LED dont la taille latérale est inférieure à 50 $\mu$m ($10^{-6}$ mètres), la taille latérale étant la longueur des côtés d'une micro-LED dont la face supérieure est carrée ou rectangulaire. Les longueurs des côtés de la face supérieure d'une micro-LED conditionnent donc le périmètre de cette face supérieure.

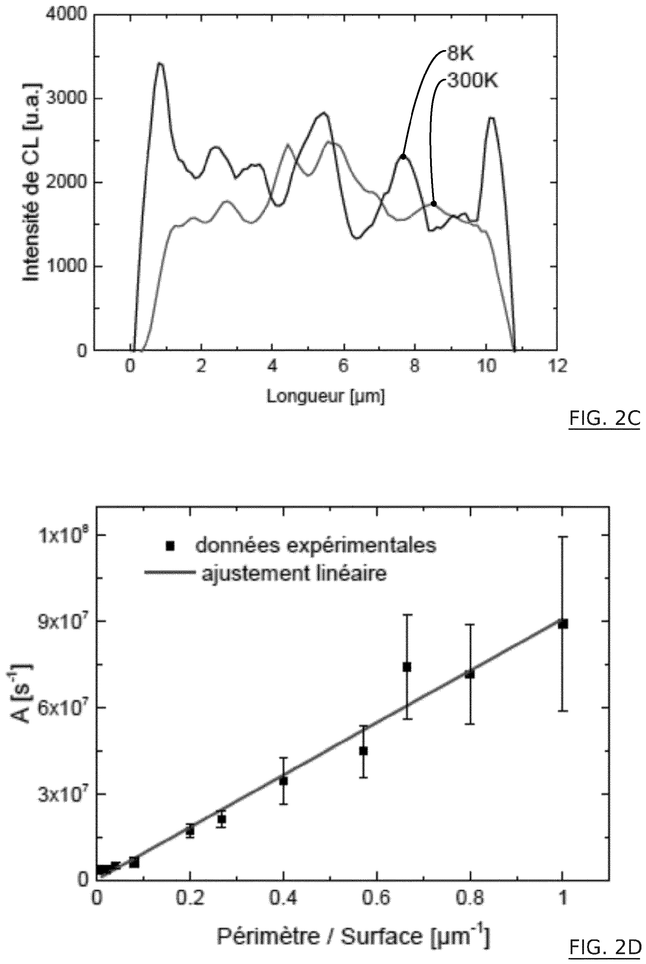

La figure 2B est une image de cathodoluminescence à température ambiante d'une micro-LED de 7$\mu$m de taille latérale. Cette figure montre clairement que cette baisse d'efficacité des micro-LEDs est associée à une moindre luminescence des bords de la LED. La figure 2C est un graphe qui compare les profils de cathodoluminescence à des températures de 300K (kelvin) et à 8K. Cette figure fait clairement apparaître que lorsque la température augmente, en bord de micro-LED, les excitons localisés à basse température sont délocalisés vers les centres de recombinaison non radiatifs.

Cet effet de bord est d'autant plus important que le rapport périmètre sur surface, approximativement proportionnel à l'inverse de la taille de la micro-LED, augmente. Cela ressort clairement de la figure 2D. Cette figure illustre la variation du paramètre A de recombinaison de Shockley-Read-Hall (SRH) en fonction de ce rapport périmètre sur surface.

Cet effet de bord est très probablement lié aux défauts laissés par la gravure 10, destinée à délimiter spatialement les différentes vignettes 550A-550E dans la couche épitaxiée 500 pleine plaque sur leur substrat 300. En effet, la gravure 10 par exemple de type RIE altère le pourtour des vignettes 550A-550E destinées à former chaque micro-LED 570A, 570B. Ces zones altérées sont référencées 520A, 520B en figure 1C qui est un agrandissement de la zone A référencée en figure 1B. Au niveau des puits quantiques 590 formés dans les micro-LED 570A-570D, ces défauts non radiatifs piègent les porteurs leur interdisant de se recombiner radiativement, ce qui fait chuter le rendement des micro-LED 570A-570D.

Plusieurs solutions ont été proposées pour répondre à cette problématique.

Une première solution envisageable consiste à optimiser la surface disponible du pixel en réalisant des micro-LED dont la surface est proche de celle du pas de pixellisation, et dont la géométrie minimise le rapport P/S, P étant le pas des pixels et S étant la surface de la micro-LED associée au pixel. Un inconvénient de cette solution est que la proximité des pixels augmente les effets dits de chevauchement, habituellement désigné « cross-talk », entre pixels.

Une seconde solution envisagée consiste à forcer l'injection des porteurs au centre de la micro-LED, de sorte que les porteurs ne puissent pas diffuser jusqu'aux bords de la micro-LED. Pour ce faire, on peut prévoir que le contact de type p n'occupe pas toute la surface du GaN formant la micro-LED. Il faut pour cela que la longueur de diffusion des porteurs dans le GaN soit inférieure à la distance entre le bord du contact p et le bord du pixel. Ainsi, les porteurs n'atteignent pas les bords du pixel. Cependant, cette solution présente pour inconvénient d'induire une perte importante de la surface émissive, surtout dans le cas des micro-LEDs. Pour une même surface, un écran portant ces micro-LEDs présentera donc une intensité lumineuse plus faible.

De façon générale, les techniques de gravure sont connues comme étant génératrices de problèmes. Leurs effets néfastes sont de plusieurs ordres : rugosification de la surface, contamination chimique liée à la chimie des gaz utilisés, niveaux associés aux lacunes d'azote, etc. Il a notamment été montré que les surfaces de GaN dopé p (Mg) sont impactées par la gravure ICP (gravure plasma à couplage inductif), ce qui induit une très nette réduction de la concentration en accepteurs dans les zones proches de la surface. Cela est en particulier expliqué dans la publication« Electrical effect of plasma damage in p-GaN Induced by Reactive Ion Etching ,» Cao et AI. Appl. Phys. Lett. 75, 2569,(1999).

Il a été également montré que la gravure RIE ou ICP induit des niveaux pièges dans le gap du GaN. Cela est en particulier expliqué dans la publication Kodera et AI. PSS. A 2017 ,1700633 « Impact of Plasma damaged layer removal on GaN HEMT devices ». La concentration d'oxygène est aussi augmentée, d'un facteur 3, dans la zone impactée par la gravure sèche, probablement en raison de l'oxydation des couches de surface, corrélativement à l'apparition d'une sous-stoechiométrie en azote. De plus, la zone de surface devient amorphe sur quelques nm (10-9 mètres). Dans cette même publication de Kodera et AI. il est montré qu'un traitement chimique post gravure approprié permet de réduire les effets négatifs de la gravure. L'analyse SIMS (Spectrométrie de Masse à Ionisation Secondaire) montre cependant que l'élimination des impuretés en surface induites par la gravure n'est pas totale.

Les effets de la gravure RIE ont été également étudiés pour déterminer s'il était possible de reprendre des contacts sur des surfaces gravées. Il semble impossible d'obtenir un contact de type p avec une résistance compatible avec les applications sur une surface gravée. Des recuits du type RTA (Rapid Thermal Annealing signifiant recuit thermique rapide) permettent d'améliorer le contact sans pour autant récupérer des contacts ohmiques. Cela a notamment été montré dans la publication Chang et AI. « The Variation of Ohmic Contacts and Surface Characteristics », J. of the Electrochemical Society » 149 n°7 (G367-G369) 2002.

Pour pallier ces problèmes dans le cas des micro-LEDs, il est possible de mettre en oeuvre des procédés de passivation des flancs de gravure. Ces procédés consistent à déposer une couche du type $SiO2$ sur les flancs de gravure pour éviter toute recombinaison non radiative sur les bords des vignettes 550A-550E. Outre que ceci devrait être associé à un traitement chimique préliminaire pour éliminer (mais seulement partiellement) la zone de défauts, ceci ajoute des étapes technologiques supplémentaires délicates à maîtriser. Cela tend ainsi à augmenter significativement la complexité et le coût de l'obtention des micro-LEDs.

Comme décrit ci-dessus, les solutions connues pour former des vignettes faites d'un nitrure (N) obtenu de préférence à partir d'au moins l'un parmi le gallium (Ga), l'indium (In) et l'aluminium (AI), induisent de nombreux problèmes lorsque ces vignettes sont utilisées pour former des micro-LEDs. Ces solutions connues induisent également des problèmes lorsque les vignettes sont utilisées pour réaliser des dispositifs électroniques de puissance tels que des transistors de puissance, par exemple des transistors HEMT (acronyme de leur appellation anglo-saxone « High Electron Mobility Transistor » signifiant transistor à effet de champ à haute mobilité d'électrons). Ces solutions connues de réalisation de vignettes conduisent en pratique à des performances électriques relativement faibles des transistors de type HEMT.

La publication, ZUBIA D ET AL: "Nanoheteroepitaxial growth of GaN on Si by organometallic vapor phase epitaxy", APPLIED PHYSICS LETTERS, AI P PUBLISHING LLC, US, vol. 76, no. 7, 14 février 2000 (2000-02-14), pages 858-860, XP012025868, ISSN: 0003-6951, DOI: 10.1063/1.125608 décrit un procédé de croissance épitaxiale d'une couche de nitrure (GaN) sur un substrat de type SOI comprenant une couche de $SiO2$, et une couche de silicium correspondant à la couche cristalline. Le document US 2010/109126 A1 décrit la formation de plots formés d'une couche de fluage en verre borophosphosilicate recouverte d'une couche cristalline semi-conductrice, ces plots étant utilisés pour former des diodes électroluminescentes à base de nitrure de gallium.

Il existe donc un besoin consistant à limiter voire à supprimer les inconvénients des solutions connues. La présente invention a notamment pour objectif de proposer une solution pour répondre à ce besoin.

Un autre objectif de la présente invention est de proposer une solution pour obtenir à la surface d'un substrat une pluralité des micro-LED présentant une brillance améliorée et/ou une très haute résolution.

Un autre objectif de la présente invention est de proposer une solution pour améliorer les performances électriques des dispositifs de puissance, par exemple des transistors de puissance de type HEMT.

Les autres objets, caractéristiques et avantages de la présente invention apparaîtront à l'examen de la description suivante et des dessins d'accompagnement. Il est entendu que d'autres avantages peuvent être incorporés.

RÉSUMÉ

Pour atteindre cet objectif, selon un mode de réalisation la présente invention prévoit un procédé d'obtention d'une pluralité de vignettes destinées chacune à former un dispositif électronique ou opto-électronique. Chaque vignette est faite au moins en partie d'un nitrure (N) obtenu de préférence à partir d'au moins l'un parmi le gallium (Ga), l'indium (In) et l'aluminium (Al).

Le procédé comprend les étapes successives suivantes:

- fournir un empilement comprenant un substrat et au moins les couches suivantes successivement disposées depuis le substrat:

  ▪ une première couche, dite couche de fluage, faite en un matériau présentant une température de transition vitreuse, la couche de fluage présentant une température de transition vitreuse $T_{transition\ vitreuse}$,
  ▪ une deuxième couche, cristalline, dite couche cristalline, différente de la couche de fluage,

- former des plots par gravure au moins de la couche cristalline et d'au moins une portion de la couche de fluage de manière à ce que :

  ○ chaque plot comporte au moins :

    ▪ un premier tronçon, dit tronçon de fluage, formé par une portion au moins de la couche de fluage,
    ▪ un deuxième tronçon, cristallin, dit tronçon cristallin, formé par la couche cristalline et surmontant le tronçon de fluage,

  ○ les plots soient répartis sur le substrat de manière à former une pluralité d'ensembles de plots,

- faire croître par épitaxie une cristallite sur certains au moins desdits plots et :

  ▪ poursuivre la croissance épitaxiale des cristallites jusqu'à coalescence des cristallites portées par les plots adjacents d'un même ensemble de manière à former sur chaque ensemble une vignette de nitrure,
  ▪ interrompre la croissance épitaxiale des cristallites avant que des cristallites appartenant à deux ensembles distincts n'entrent en coalescence, de sorte à ce que les vignettes de chaque ensemble soient distantes les unes des autres.

Ainsi, le procédé proposé prévoit la réalisation de vignettes de nitrure (GaN par exemple) à partir d'ensembles de plots gravés dans un empilement comprenant une couche cristalline destinée à l'épitaxie du nitrure et une couche de fluage. Au cours de leur croissance épitaxiale, les cristallites formées au sommet des plots d'un même ensemble de plots se rejoignent pour former une vignette, chacune des vignettes étant destinée à former un dispositif optoélectronique tel qu'une micro-LED par exemple ou un dispositif électronique tel qu'un transistor de puissance, par exemple de type HEMT.

Comme cela sera indiqué plus en détail par la suite, l'utilisation de ces réseaux de plots permet de former par épitaxie des vignettes de nitrure sans ou avec peu de dislocations. En effet, l'utilisation d'ensembles de plots permet de tirer partie des propriétés de fluage de certains matériaux des plots à la température d'épitaxie afin d'aligner les cristallites de nitrure qui croissent par pendeo-épitaxie à partir de plots adjacents jusqu'à former les vignettes, ceci sans former de défauts de coalescence.

Plus précisément, lors de l'épitaxie, la portion du plot qui est formée par le tronçon de fluage atteint (ou dépasse) sa température de transition vitreuse ou une température très proche de cette dernière. Sous l'effort d'une contrainte mécanique, cette portion de plot peut ainsi se déformer. Ainsi lorsque deux cristallites qui sont supportées par un même ensemble de plots entrent en contact et coalescent, les contraintes mécaniques générées par ce contact sont transférées aux plots et donc aux tronçons de fluage. Ces derniers se déforment, absorbant de ce fait une partie voire toutes les contraintes mécaniques. On peut ainsi réduire considérablement, voire éviter, l'apparition et la propagation de dislocations au niveau des joints de coalescence entre les cristallites qui forment une vignette de nitrure.

En particulier, si les cristallites sont désorientées les unes par rapport aux autres dans le plan dans lequel le substrat s'étend principalement (« twist ») ou hors plan (« tilt »), la désorientation entre cristallites résulte en la création d'un joint de grains à la coalescence. Ce joint de grains est fortement énergétique puisqu'il résulte de la superposition des champs de contrainte des défauts qui le composent. Si les cristallites poussent sur des plots qui peuvent se déformer comme le permet le procédé décrit, les cristallites adjacentes s'orientent alors dans le plan ou hors plan pour minimiser l'énergie totale du système sans qu'il y ait formation de joints de grains. Au contraire, si les cristallites poussent sur des plots qui ne peuvent pas se déformer, (comme cela serait le cas avec les procédés de l'état de la technique de type pendeo épitaxie ou ELOG acronyme de Epitaxial Lateral Over Growth signifiant croissance épitaxiale par recroissance latérale), il y a formation de joints de grains et donc apparition de dislocations.

Ainsi le procédé décrit propose une solution clairement opposée à toutes les solutions de l'état de la technique présentées ci-dessus et qui prévoient de délimiter par gravure des vignettes à partir d'une couche commune initiale obtenue par épitaxie. Le procédé proposé permet de se passer totalement d'une étape de gravure pour délimiter les vignettes. Or, comme indiqué ci-dessus cette étape de gravure s'avère très pénalisante pour l'efficacité des micro-LEDs. Par ailleurs, les solutions développées pour atténuer, sans les éliminer, les inconvénients de cette gravure complexifient considérablement les procédés et induisent d'autres inconvénients. La solution proposée dans le cadre de la présente invention repose ainsi sur un procédé simple et aisément reproductible, qui permet d'obtenir des vignettes qui n'ont pas été altérées par des procédés de gravures et qui ne présentent pas ou très peu de défauts liés aux joints de coalescence. L'invention permet ainsi d'augmenter considérablement l'efficacité des micro-LEDs obtenues à partir de ces vignettes.

Cette solution permet ainsi d'améliorer la brillance des écrans haute résolution réalisés à partir de ces micro-LEDs. En effet elle permet d'obtenir des micro-LEDs de tailles très petites. Les dimensions des vignettes sont déterminées par le réseau de plots. Il est possible de réaliser des vignettes de quelques $\mu$m à quelques centaines de $\mu$m ($10^{-6}$ mètres) en mettant en oeuvre ce procédé.

La densité de dislocations dans ces vignettes de GaN est inférieure ou est de l'ordre de 1 à 2 $10^{E}8$ / cm$^2$. L'efficacité radiative des puits quantiques est très élevée.

La précision des procédés mis en oeuvre pour réaliser le réseau de plots, déterminera en partie au moins la plus faible dimension possible pour les micro-LED et donc la résolution d'un écran comprenant ces micro-LED. Par exemple, pour des réseaux de plots élaborés par impression nanométrique (nanoimprint) et par lithographie par faisceau d'électron (e-beam), on peut atteindre des tailles de plots de 50 nm et des périodes de 150 à 200nm. Il est alors possible d'obtenir des tailles de vignettes de 1 à 2 $\mu$m. Cela correspond aux tailles de pixels recherchées pour les micro- écrans (souvent désignés $\mu$-display) haute résolution.

Par ailleurs ce procédé permet de réaliser directement des micro-LEDs présentant chacune une taille correspondant à la taille initiale de la vignette, notamment si une hétéro-structure à puits quantiques est élaborée sur ces vignettes de nitrure.

Le procédé proposé permet ainsi d'obtenir des micro-LEDs de tailles très faibles et présentant une forte brillance. Ce procédé est donc particulièrement avantageux pour réaliser des écrans haute résolution et à forte brillance.

Le procédé proposé permet également d'obtenir des vignettes que l'on utilise pour la fabrication de dispositifs électroniques de puissance tel que des transistors de type HEMT par exemple. Les vignettes obtenues présentent un taux de dislocations réduit et une meilleure qualité cristalline, les performances électriques des dispositifs de puissance s'en trouvent améliorées.

L'invention permet ainsi d'obtenir des couches de nitrure (N) obtenue à partir d'au moins l'un parmi le gallium (Ga), l'indium (In) et l'aluminium (Al) présentant une densité de dislocations significativement réduite.

Par conséquent, le procédé selon l'invention apporte une solution particulièrement efficace au problème de la génération de défauts liés à la coalescence. Ce procédé, tout particulièrement lorsqu'il est appliqué à des cristallites réalisées sur substrat du type SOI (silicium sur isolant) et de dimensions nanométriques, résulte en une réduction très notable de la densité de défauts liés à la coalescence, permettant la réalisation de pseudo-substrats avec de très faibles densités de dislocations.

Un autre aspect de la présente invention concerne un procédé de formation d'une pluralité de diodes électroluminescentes (LEDs) comprenant au moins les étapes successives suivantes :

- formation d'une pluralité de vignettes destinées chacune à former une LED, la pluralité de vignettes étant obtenue en mettant en oeuvre le procédé décrit ci-dessus,
- réalisation dans les vignettes d'au moins l'un parmi :

    ◦ au moins une jonction p/n,
    ◦ au moins un puit quantique.

Un autre aspect de la présente invention concerne un dispositif microélectronique comprenant un substrat surmonté d'une pluralité de vignettes faites chacune d'un nitrure (N) obtenu de préférence à partir d'au moins l'un parmi le gallium (Ga), l'indium (In) et l'aluminium (Al). Le dispositif comprend également une pluralité de plots s'étendant entre le substrat et la pluralité de vignettes, chaque vignette étant entièrement supportée par un ensemble de plots pris parmi ladite pluralité de plots. Chaque plot comprend au moins :

- un premier tronçon, dit tronçon de fluage, présentant une température de transition vitreuse $T_{transition}$ vitreuse,

- un deuxième tronçon, dit tronçon cristallin formé d'un matériau cristallin, le tronçon de fluage et le tronçon cristallin étant successivement disposés depuis le substrat.

Le matériau du tronçon de fluage et ledit nitrure dans lequel sont faites les vignettes étant choisis de manière à ce que:

$$T_{\text{épitaxie}} \geq k1 \times T_{\text{transition vitreuse}}, \text{ avec } k1=0,8,$$

$T_{\text{épitaxie}}$ étant la température minimale permettant la formation par épitaxie dudit nitrure dans lequel sont faites les vignettes.

Ainsi, chaque vignette comprend ou est formée d'une couche continue de nitrure (N) obtenue de préférence à partir d'au moins l'un parmi le gallium (Ga), l'indium (In) et l'aluminium (Al). Chaque vignette est entièrement supportée par des plots lors de la croissance par épitaxie, c'est à dire lors de la formation de la vignette.

Un autre aspect de la présente invention concerne un système optoélectronique comprenant un dispositif microélectronique comme décrit ci-dessus, dans lequel au moins certaines et de préférence chaque vignette forme en partie au moins une diode électroluminescente (LED).

Un autre aspect de la présente invention concerne un système comprenant un dispositif microélectronique comme décrit ci-dessus dans lequel au moins certaines et de préférence chaque vignette forme en partie au moins un transistor, de préférence un transistor à haute mobilité d'électrons (HEMT).

## BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :

Les figures 1A à 1C illustrent des étapes d'un procédé de l'état de la technique pour la réalisation de micro-LEDs.

La figure 1A représente l'empilement de départ comprenant une couche de nitrure continue.

La figure 1B représente une étape de gravure pour structurer des vignettes distinctes dans la couche continue.

La figure 1C est une vue agrandie de la figure 1A pour illustrer les zones de défauts générés par la gravure

Les figures 2A à 2C illustrent les inconvénients des solutions micro-LEDs obtenues avec les solutions de l'état de la technique.

La figure 2A est un graphe illustrant le rendement quantique d'une LED en fonction de sa taille.

La figure 2B est une image de cathodoluminescence d'une micro-LED qui montre clairement que la baisse d'efficacité de ces LEDs est associée à une moindre luminescence des bords de la LED.

La figure 2C est un graphe comparant les profils de cathodoluminescence à deux températures différentes.

La figure 2D est un graphe illustrant la variation du paramètre A de recombinaison de Shockley-Read-Hall (SRH) en fonction du rapport périmètre sur surface d'une micro-LED.

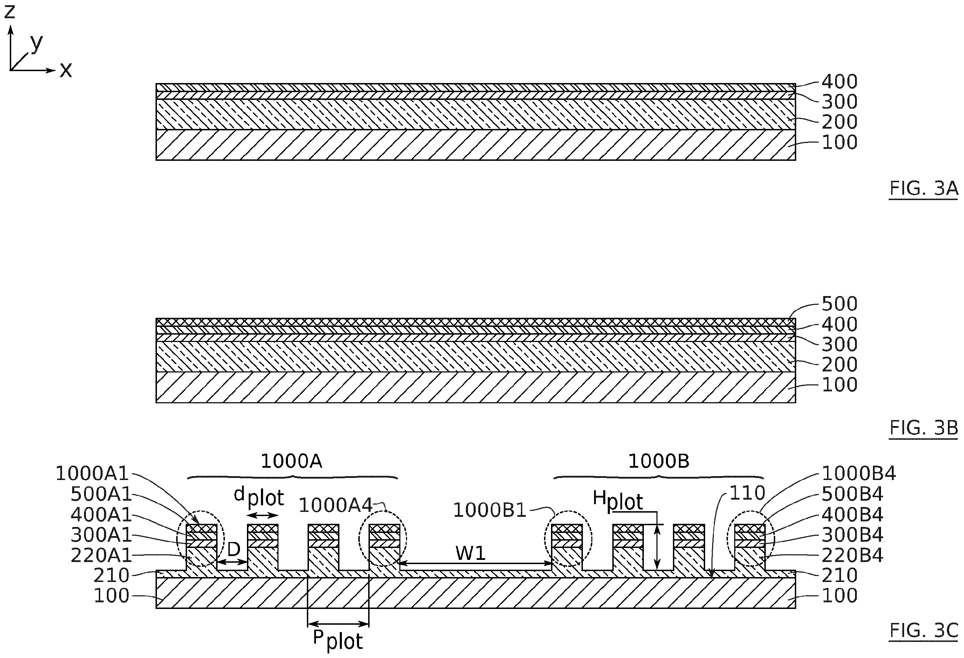

Les figures 3A à 3F illustrent des étapes d'un procédé selon un exemple non limitatif du procédé selon la présente invention.

La figure 3A illustre un exemple d'empilement à partir duquel l'on peut mettre en oeuvre un exemple de procédé selon l'invention.

La figure 3B illustre l'empilement de la figure 3A sur lequel une couche d'amorçage est formée.

La figure 3C illustre le résultat d'une étape consistant à former des ensembles de plots à partir de l'empilement de la figure 3A ou de celui de la figure 3B.

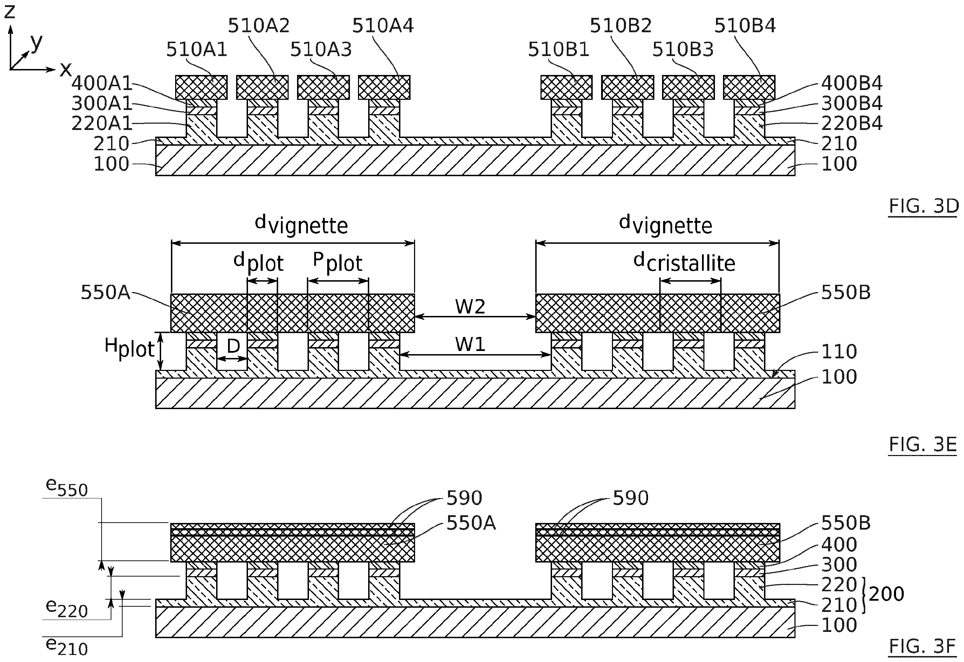

La figure 3D illustre une phase de croissance épitaxiale de cristallites sur le sommet des plots, cette phase de croissance n'étant pas achevée.

La figure 3E illustre le résultat de la croissance épitaxiale de cristallites, après coalescence des cristallites portées par des plots d'un même ensemble, les cristallites portées par des plots d'un même ensemble formant alors une vignette de nitrure.

La figure 3F illustre une étape optionnelle de réalisation de multi puits quantiques au sein de chaque vignette de nitrure.

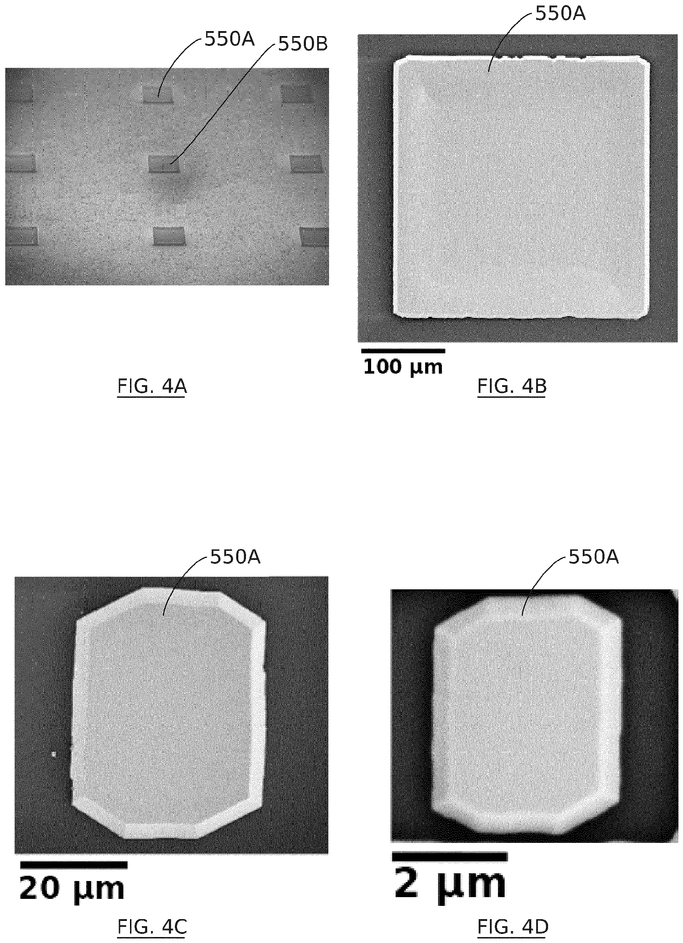

La figure 4A est une photo obtenue par microscopie électronique à balayage (MEB) montrant un substrat supportant une pluralité de vignettes obtenues avec le procédé selon l'invention.

Les figures 4B à 4D sont des photos obtenues par microscopie électronique à balayage (MEB), dont l'agrandissement est supérieur à celle de la figure 4, et montrant des vignettes de différentes tailles obtenues avec le procédé selon l'invention.

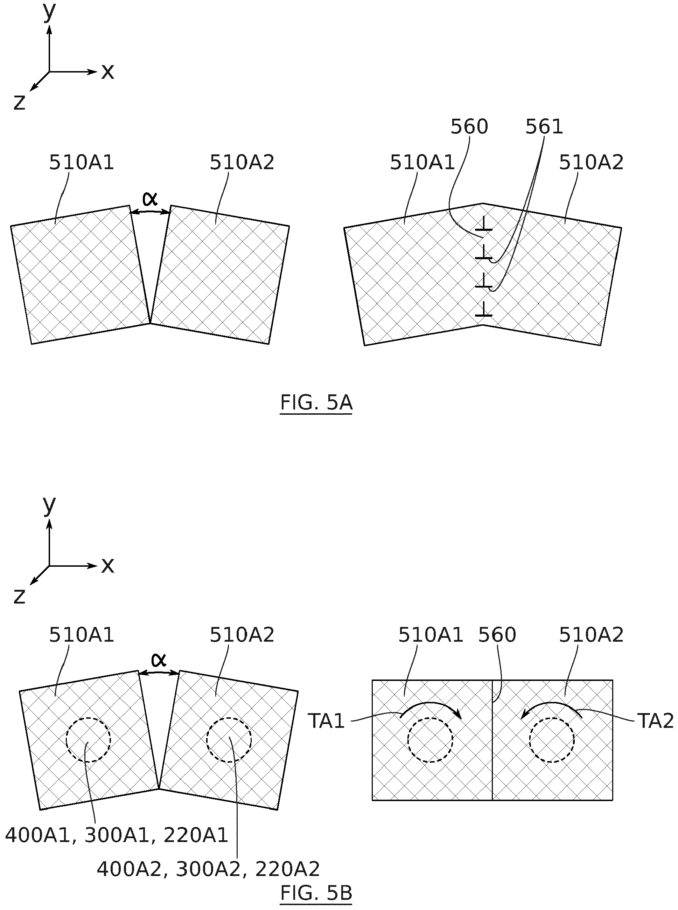

La figure 5 A illustre de manière schématique, en vue du dessus, la coalescence de deux cristallites dans le cadre d'un procédé classique de pendeo-épitaxie.

La figure 5 B illustre de manière schématique, en vue du dessus, la coalescence de deux cristallites dans le cadre d'un exemple de procédé selon la présente invention.

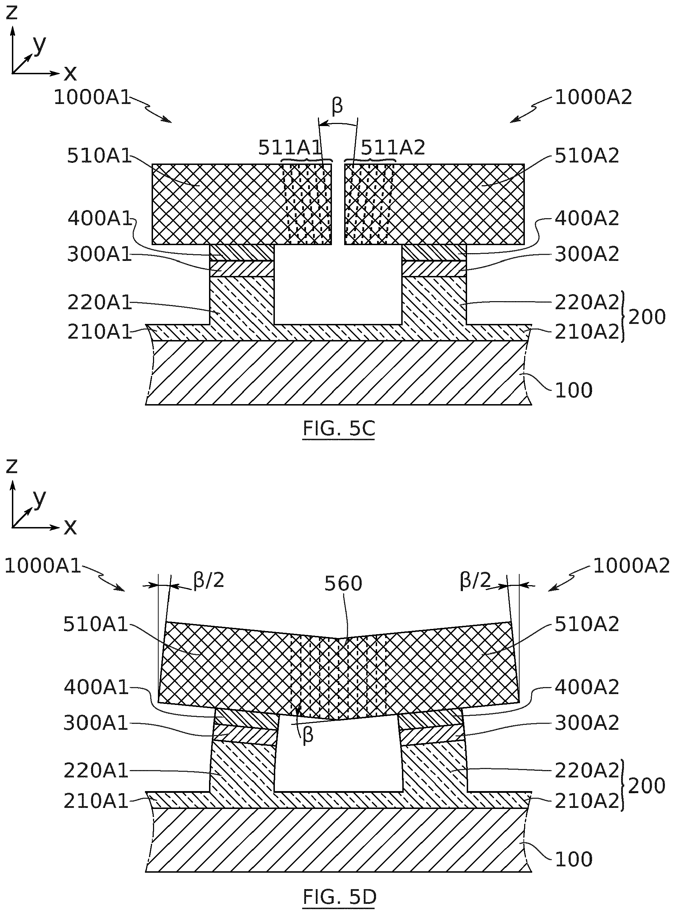

Les figures 5C et 5D, illustrent de manière schématique, en vue de côté, le processus de coalescence de deux cristallites dans le cadre d'un exemple de procédé selon la présente invention.

La figure 5C illustre une première phase qui a lieu avant coalescence des deux cristallites.

La figure 5D illustre une deuxième phase qui a lieu lors ou après coalescence des deux cristallites.

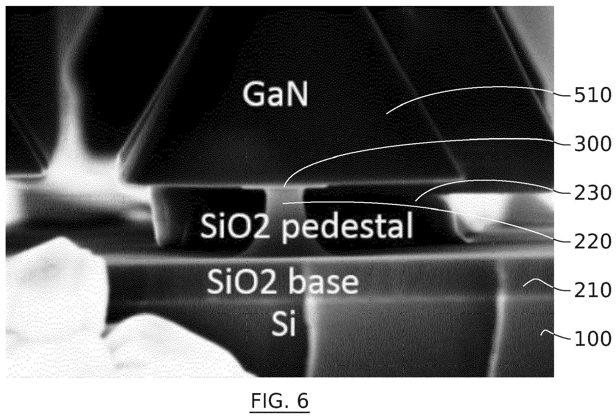

La figure 6 est une photo obtenue par MEB illustrant un plot surmonté d'une cristallite, obtenue par mise en oeuvre d'un exemple de procédé selon la présente invention.

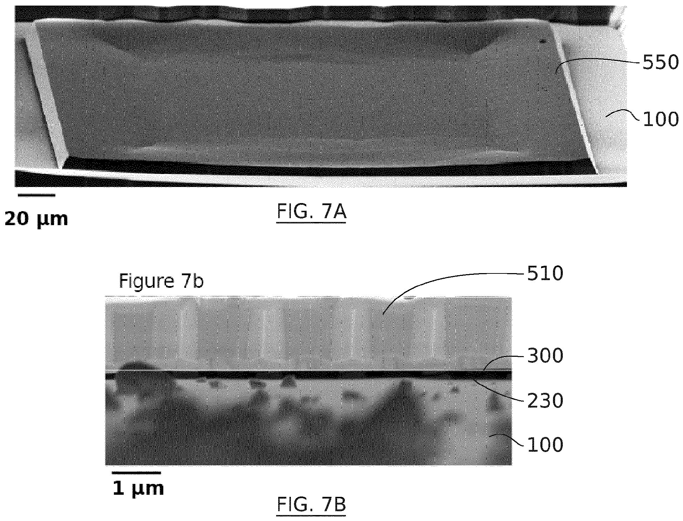

Les figures 7A et 7B qui sont des photos obtenues par MEB montrant une vignette de nitrure obtenue par épitaxie après mise en oeuvre du procédé selon la présente invention.

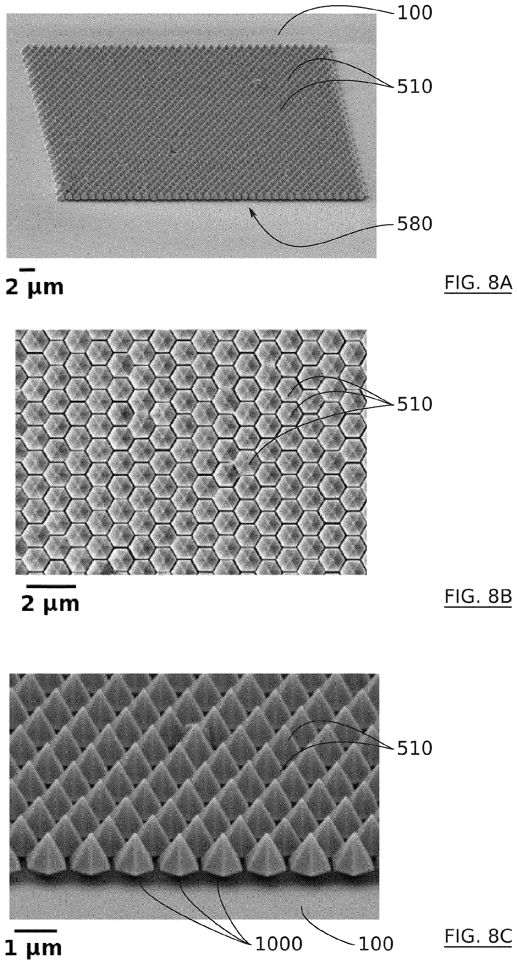

Les figures 8A à 8C sont des photos obtenues par MEB illustrant la formation de cristallites dans le cadre du procédé selon la présente invention.

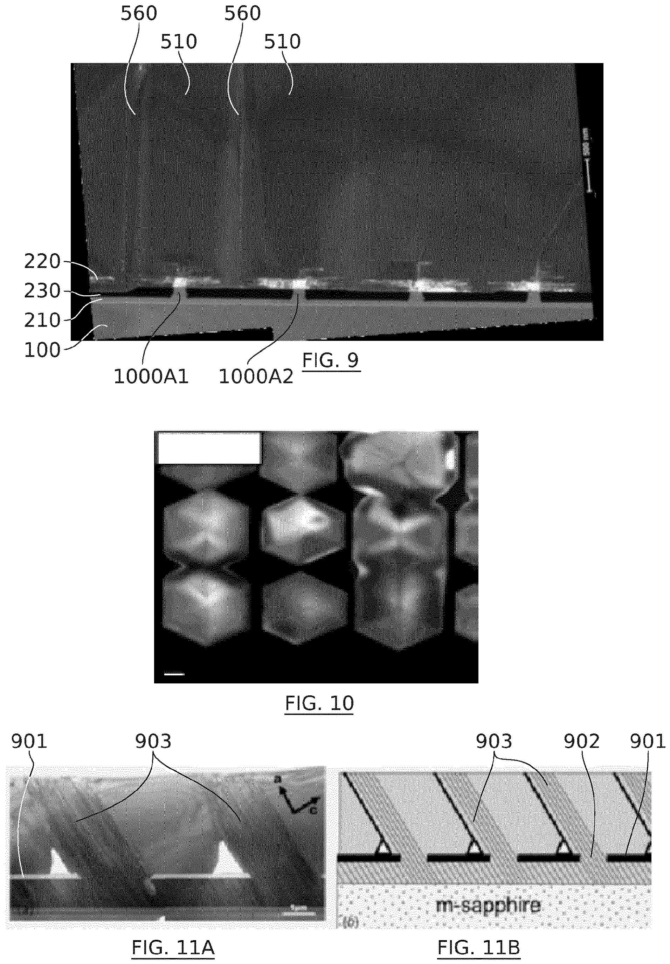

La figure 9 est une photo obtenue par microscopie électronique en transmission (MET) montrant une vignette en coupe formée par coalescence.

La figure 10 est une photo obtenue par MEB en mode « cathodoluminescence » (CL) en vue du dessus de cristallites en cours de coalescence en mettant en oeuvre le procédé selon la présente invention.

Les figures 11A et 11B sont une photo obtenue par microscopie électronique à balayage (MEB) et un schéma illustrant le résultat d'une méthode connue dans lesquels les défauts des couches de nucléation traversent toute la couche finale.

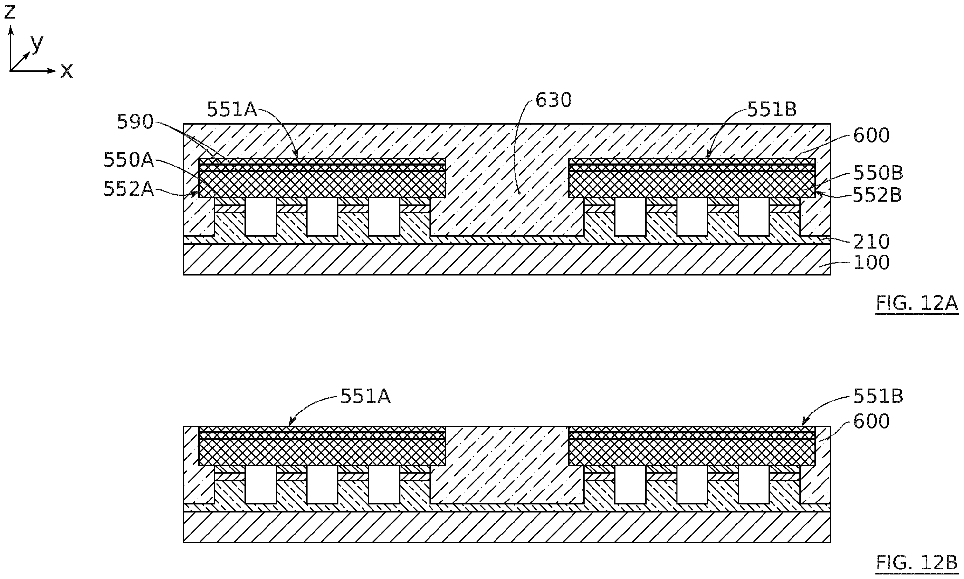

Les figures 12A à 120 illustrent des étapes d'un exemple de procédé pour réaliser des LED, typiquement des micro-LED, à partir de vignettes de nitrure supportées par des plots.

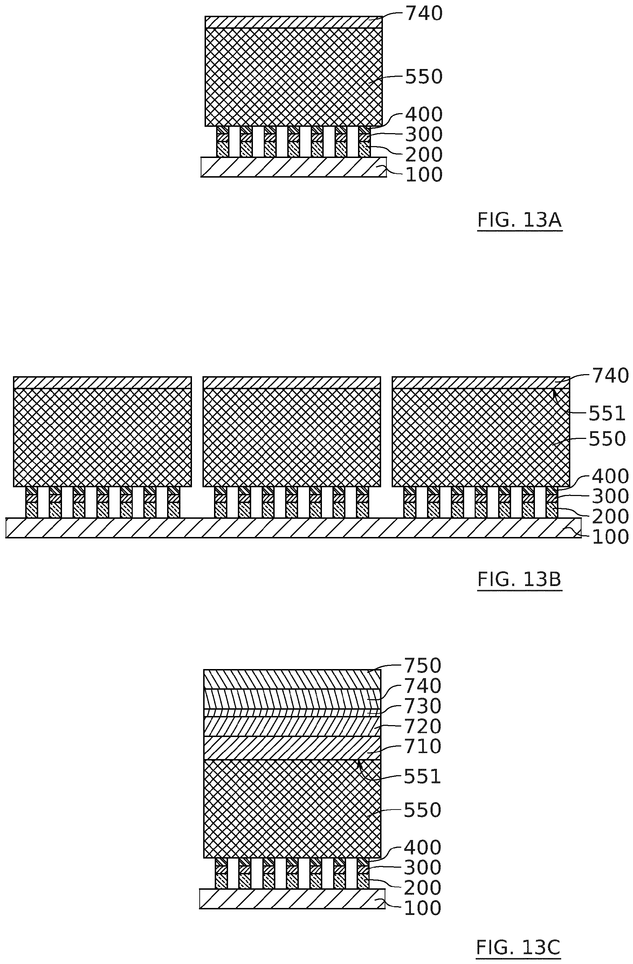

Les figures 13A à 13C illustrent, de manière schématique, plusieurs exemples de dispositifs microélectroniques, par exemple des transistors verticaux de type HEMT, obtenus en mettant en oeuvre le principe du procédé décrit ci-dessus.

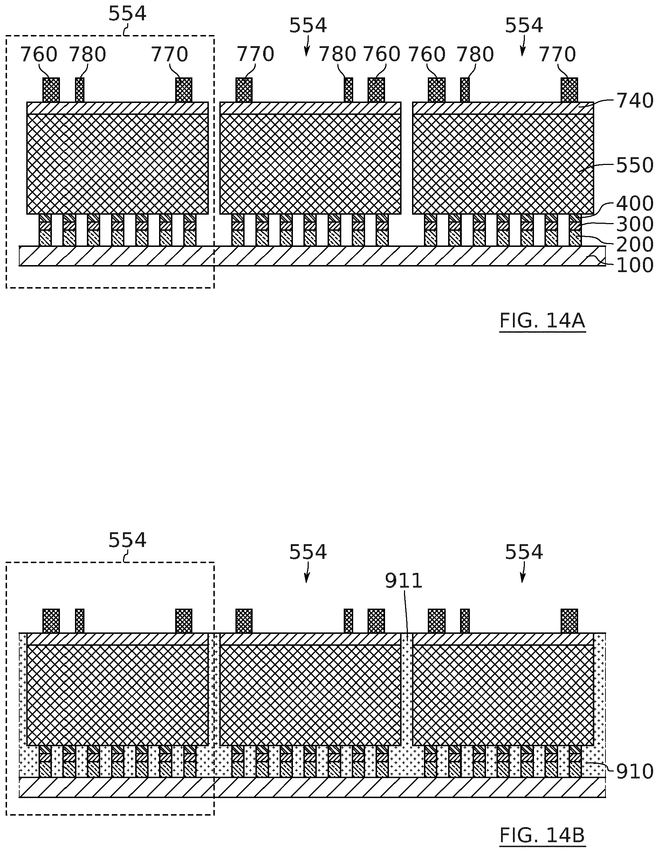

Les figures 14A à 14B illustrent, de manière schématique, des exemples de transistors réalisés sur une même plaque à partir de vignettes de nitrure supportées par des plots.

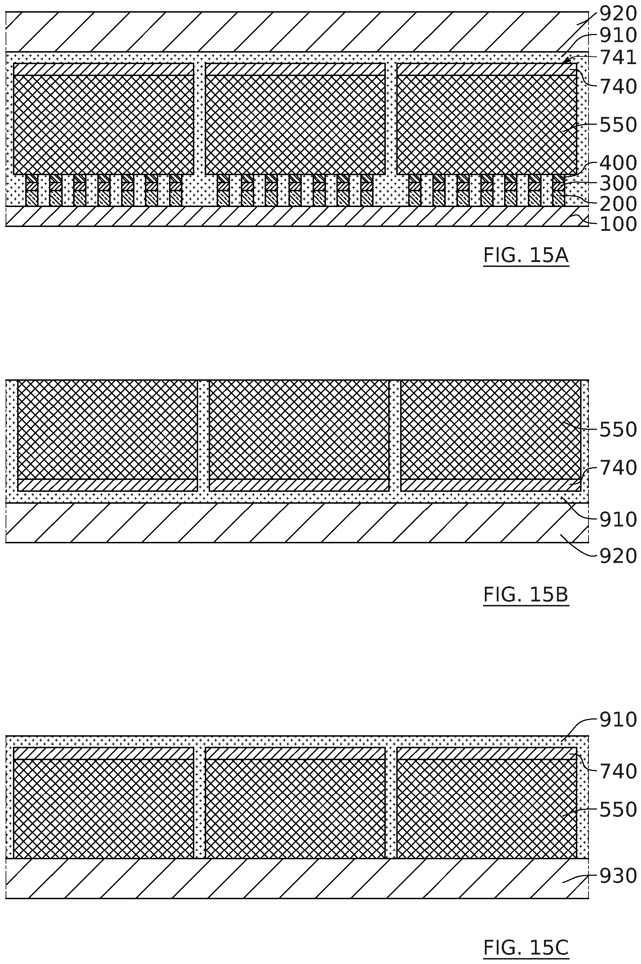

Les figures 15A à 15D illustrent, de manière schématique, des étapes d'un exemple de procédé pour réaliser sur une plaque des transistors, par exemple des transistors verticaux de type HEMT, à partir de vignettes de nitrure supportées par des plots.

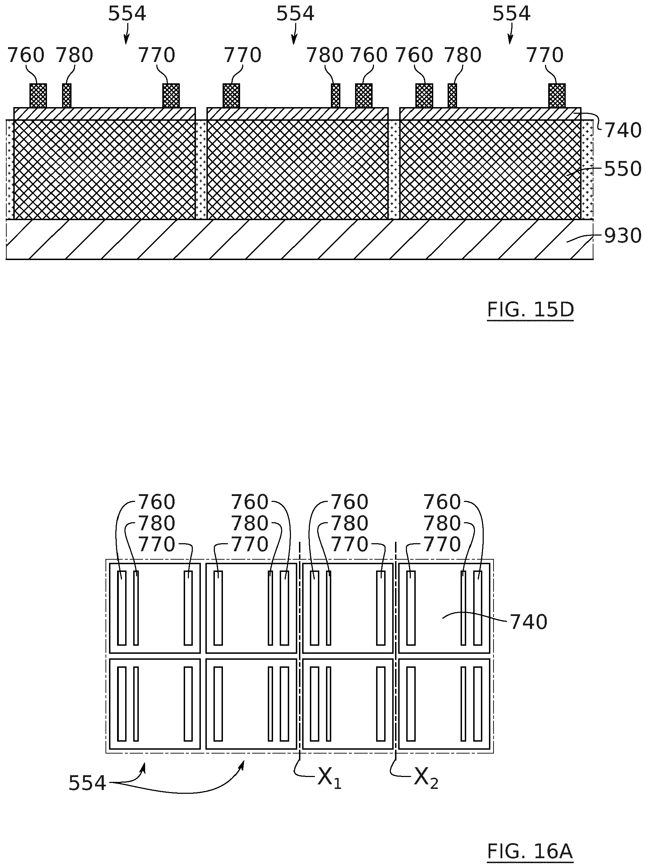

La figure 16A illustre en vue du dessus, la plaque de la figure 15D portant les transistors.

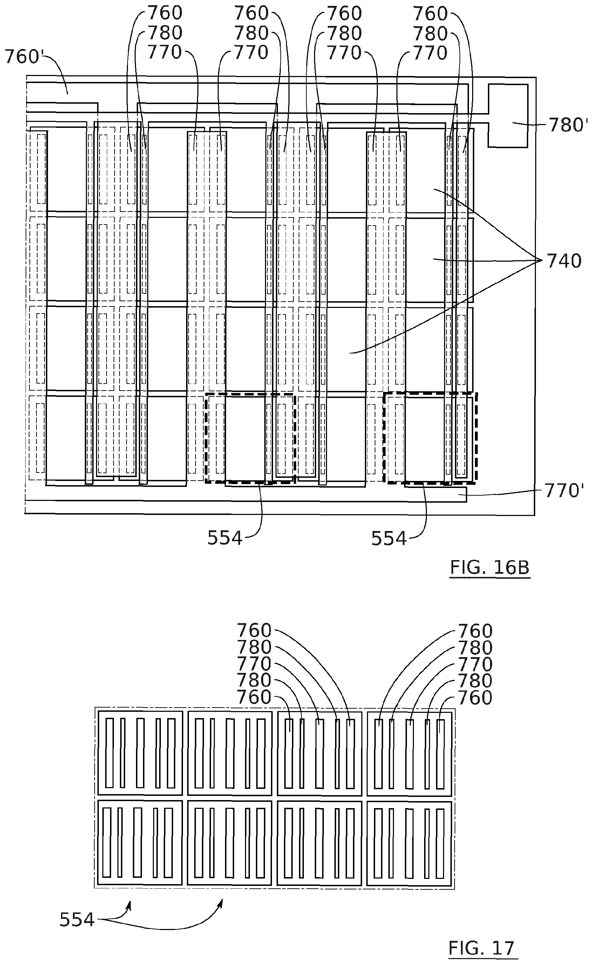

La figure 16B illustre en vue du dessus, la plaque de la figure 15D portant les transistors après réalisation des pistes électriques de connexion des sources, drains et grilles.

La figure 17 illustre en vue du dessus, une plaque portant des transistors selon une alternative au mode de réalisation illustré en figure 15D et 16A.

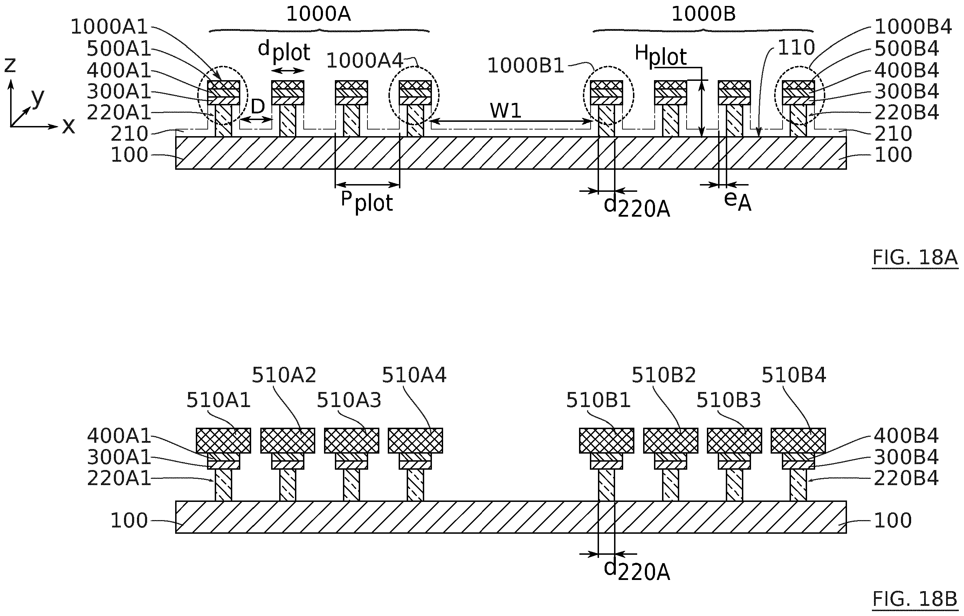

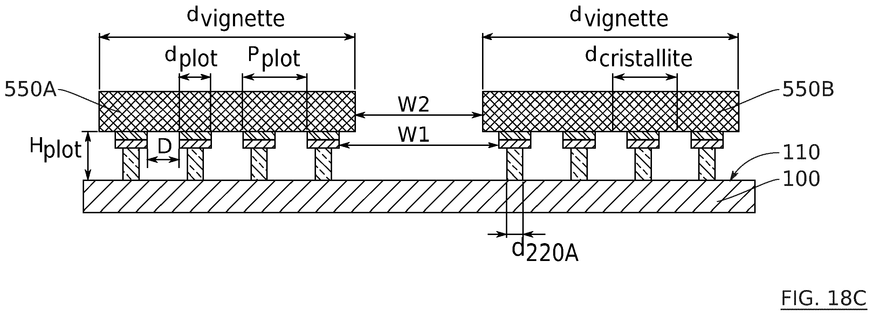

Les figures 18A à 18C illustrent, de manière schématique, des étapes alternatives aux étapes 3D à 3F. Les figures 18A à 18C illustrent un mode de réalisation dans lequel les tronçons de fluage des plots sont amincis avant croissance des cristallites.

Les figures sont données à titre d'exemples et ne sont pas limitatives de l'invention. Elles sont des représentations schématiques de principe destinées à faciliter la compréhension de l'invention et ne sont donc pas nécessairement à la même échelle que les applications pratiques. En particulier, les épaisseurs relatives des différentes couches, tronçons, cristallites et vignettes ne sont pas représentatives de la réalité.

## DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement.

Selon un exemple, la distance D séparant deux plots adjacents d'un même ensemble est inférieure à la distance W1 séparant deux plots adjacents appartenant à deux ensembles différents. $W1 > D$ et de préférence $W1 \geq 2 \times D$.

De préférence $W1 \geq k4 \times D$, avec $k4 = 1.5$, de préférence $k4 = 2$. Cela permet d'avoir des pixels de petites tailles et une densité d'intégration importante. De préférence $k4 = 5$. W1 peut être égale à 1,5 microns.

Selon un exemple, chaque plot présente une section dont la dimension maximale $d_{plot}$ est comprise entre 10 et 500 nm ($10^{-9}$ mètres), la dimension maximale $d_{plot}$ étant mesurée dans un plan parallèle à un plan (xy) dans lequel s'étend principalement une face supérieure du substrat, de préférence $20 \, nm \leq d_{plot} \leq 200 \, nm$ et de préférence $50 \, nm \leq d_{plot} \leq 100 \, nm$.

Selon un exemple, chaque vignette présente une section dont la dimension maximale $d_{vignette}$ est comprise entre 0,5 à 20 $\mu m$ ($10^{-6}$ mètres), la dimension maximale $d_{vignette}$ étant mesurée dans un plan parallèle à un plan (xy) dans lequel s'étend principalement une face supérieure du substrat, de préférence $0.8 \, \mu m \leq d_{vignette} \leq 3 \, \mu m$ et de préférence $1 \, \mu m \leq d_{vignette} \leq 2 \, \mu m$. La dimension maximale $d_{vignette}$ correspond ainsi à la dimension maximale d'une projection de la vignette dans un plan parallèle au plan xy dans lequel s'étend principalement la face supérieure du substrat.

Selon un exemple, les plots d'un même ensemble sont répartis sur le substrat de manière périodique selon une période $p_{plot}$, avec $200 \, nm \leq p_{plot} \leq 3000 \, nm$ et de préférence avec $200 \, nm \leq p_{plot} \leq 2000 \, nm$, et de préférence $200 \, nm \leq p_{plot} \leq 500 \, nm$. La période $p_{plot}$ est mesurée dans un plan parallèle à un plan (xy) dans lequel s'étend principalement une face supérieure du substrat.

W2 étant la distance séparant deux vignettes adjacentes 550A, 550B (voir W2 en figure 3D), il faut que W2 soit non nulle pour que les deux vignettes adjacentes 550A, 550B ne se touchent pas. Ainsi, $W2 > 0$.

Théoriquement et s'il n'y avait pas de recroissance latérale sur les bords des vignettes, pour que ces deux vignettes adjacentes 550A, 550B ne se touchent pas (W2 non nul), il faudrait que W1 soit strictement supérieur à $2(p_{plot}-d_{plot})/2$ soit $p_{plot}-d_{plot}$.

Selon un exemple, $W1 \geq k5 \times W2$, avec

- W1 est la distance séparant deux plots adjacents appartenant à deux ensembles distincts,

- W2 est la distance séparant deux vignettes adjacentes, W2 étant >0.

avec $k5 = 1.2$, de préférence $k5 = 1.5$, de préférence $k5 = 2$

Alternativement, les plots d'un même ensemble sont répartis sur le substrat de manière non périodique. De manière optionnelle mais avantageuse, les vignettes sont réparties sur le substrat de manière périodique.

Selon un exemple, la couche de fluage est faite d'un matériau visqueux. Il présente une transition visco-plastique. De préférence ce matériau est pris parmi :

- un oxyde de silicium SixOy, x et y étant des entiers, et de préférence la couche de fluage est en SiO2,
- un verre,
- un verre en borosilicate,
- un verre en borophosphosilicate (BPSG).

De manière optionnelle, la croissance épitaxiale est effectuée à une température $T_{épitaxie}$, telle que : $T_{épitaxie} \geq k1 \times T_{transition\ vitreuse}$, avec $k1 \geq 0,8$.

Selon un exemple, k1 = 1, et de préférence k1 = 1,5. Selon un exemple de réalisation, k1 = 0.87 ou k1 = 0.9. Selon un exemple particulièrement avantageux, k1= 0.92. Ainsi, dans le cas où les tronçons de fluage sont formés en SiO2, $T_{épitaxie} \geq 1104°C$, $T_{transition\ vitreuse}$ pour le SiO2 étant égale à 1200°C. Selon un exemple de réalisation encore plus préférentiel, k1 = 0.95. Selon un exemple de réalisation encore plus préférentiel, k1 = 1, et de préférence k1 = 1,5.

Selon un exemple, $T_{épitaxie} \leq k2 \times T_{fusion\ min}$, $T_{fusion\ min}$ étant la température de fusion la plus faible parmi les températures de fusion des tronçons formant le plot, avec $k2 \leq 0,9$ et de préférence $k2 \leq 0,8$. Selon un exemple de réalisation, k2 = 0.9. Cela permet d'éviter une diffusion des espèces du matériau dont la température de fusion est la plus faible. Ainsi, dans le cas où le plot est formé de tronçons de fluage en SiO2 et de tronçons cristallins en silicium, $T_{épitaxie} \leq 1296°C$. En effet, $T_{fusion\ min}$ est égale à la température de fusion du silicium puisque la température de fusion du silicium est égale à 1440° et la température de fusion du SiO2 est égale à 1970°C. De préférence, k2= 0.8.

Selon un exemple, les plots comprennent au moins une couche tampon surmontant la couche cristalline, et faite en un matériau différent de celui des vignettes de nitrure. Selon cet exemple, les vignettes de nitrure sont faites en nitrure de gallium (GaN) et la couche tampon est en nitrure d'aluminium (AIN). Cela permet, d'éviter l'apparition du phénomène de melt back etching (gravure par refusion), généré par la très forte réactivité entre le gallium et le silicium.

Selon un exemple, la couche tampon est formée par dépôt par épitaxie au-dessus de la couche cristalline, avant l'étape de formation des plots par gravure. Ainsi, l'empilement comprend, avant l'étape de croissance épitaxiale des vignettes de nitrure, au moins ladite couche tampon. Le fait de former la pluralité de plots par gravure après la formation de la couche tampon au-dessus de la couche cristalline, permet d'éviter que la couche tampon ne se dépose entre les plots, typiquement sur le fond de la couche de fluage ou ne se dépose sur les parois des tronçons formés par la couche cristalline, ce qui aurait été le cas si cette étape de formation de la couche tampon avait été réalisée après gravure de l'empilement pour former les plots. On évite ainsi la croissance épitaxiale des vignettes de nitrure à partir de la couche de fluage. Naturellement, on observe cet avantage lorsque la croissance de la couche de nitrure destinée à former chaque vignette s'effectue par épitaxie de manière sélective. Cette croissance s'effectue en effet sur le matériau de la couche tampon mais ne s'effectue pas sur le matériau des tronçons de fluage. Tel est le cas lorsque ces derniers sont en SiO2, la couche tampon est en AIN et la vignette de nitrure formée par épitaxie, par exemple selon une technique MOVPE (épitaxie en phase vapeur aux organométalliques), est du GaN. Ainsi ce dernier ne se dépose pas au pied des plots.

Selon un exemple, les plots comprennent, avant l'étape de croissance épitaxiale des vignettes de nitrure, au moins une couche d'amorçage, surmontant ladite couche tampon et faite de nitrure de gallium (GaN).

Selon un exemple, l'empilement comprend, avant ladite étape de formation des plots par gravure, au moins une couche d'amorçage, surmontant ladite couche cristalline, la couche d'amorçage étant faite du même matériau que celui des vignettes de nitrure. Ainsi, dans un mode de réalisation dans lequel les vignettes de nitrure sont du GaN, la couche d'amorçage est également en GaN. Avantageusement, cette couche d'amorçage permet de faciliter la reprise de la croissance épitaxiale pour la formation des cristallites. Cette caractéristique est d'autant plus avantageuse que la surface du sommet des plots est faible.

Selon un exemple, chaque plot présente une face supérieure et la croissance par épitaxie des cristallites s'effectue en partie au moins et de préférence uniquement à partir de ladite face supérieure. De préférence, la couche tampon est disposée directement au contact de la face supérieure du tronçon cristallin ou au contact de la face supérieure du tronçon formé par la couche amorçage.

Si le sommet du plot, c'est-à-dire la face supérieure du plot, découverte, est formé par le tronçon cristallin, alors on fait croître par épitaxie les cristallites directement au contact de la couche cristalline. Si le sommet du plot est formé par la couche d'amorçage, alors on fait croître par épitaxie les cristallites directement au contact de la couche d'amorçage. Si le sommet du plot est formé par la couche tampon, alors on fait croître par épitaxie les cristallites directement au contact de la couche tampon. De préférence, la couche d'amorçage est disposée directement au contact de la face supérieure du tronçon cristallin.

Selon un exemple, au moins l'une parmi la couche tampon et la couche d'amorçage conserve une épaisseur constante au cours de l'étape de croissance par épitaxie.

Selon un exemple, fournir ledit empilement comprend fournir un substrat élaboré de type silicium sur isolant (SOI) comprenant un substrat de base surmonté successivement d'une couche d'oxyde formant ladite couche de fluage et d'une couche semi conductrice formant ladite couche cristalline.

Selon un exemple, le tronçon de fluage présente une hauteur $e_{220}$ telle que $e_{220} \geq 0.1 \times d_{plot}$, $d_{plot}$ étant le

diamètre du plot ou plus généralement la distance bord à bord du plot prise, au niveau du tronçon de fluage et dans une direction parallèle à un plan (xy) dans lequel s'étend principalement une face supérieure du substrat, de préférence $e_{220} \geq 1 x d_{plot}$. Ces valeurs, permettent d'obtenir une déformation suffisante pour réduire les contraintes au niveau du joint de grain.

Selon un exemple, les plots présentent une hauteur $H_{plot}$, et dans lequel deux plots adjacents sont distants d'une distance D, telle que :

$H_{plot}$/ D < 2 et de préférence $H_{plot}$ / D $\leq$ 1.

Selon un exemple, la couche cristalline est à base de silicium et de préférence la couche cristalline est en silicium.

La couche cristalline peut être aussi à base de matériaux autres que Si et qui permettent l'épitaxie de matériaux nitrures. Par exemple, la couche cristalline peut être à base de SiC ou de $Al_2O_3$. Ces matériaux sont en outre utilisables sous la forme de SiCOI (SiC on Insulator, c'est-à-dire de SiC sur isolant) ou de SOS (silicium sur saphir).

Selon un exemple de réalisation la couche cristalline est une couche mono-cristalline.

Selon un exemple de réalisation, la couche de fluage est au contact direct avec le substrat. La couche de fluage est au contact direct de la couche cristalline. Selon un exemple de réalisation, la couche de nitrure formant chaque vignette que l'on réalise par coalescence de cristallites est au contact direct de la couche cristalline. Selon un autre mode de réalisation, on prévoit au moins une couche intermédiaire entre la couche cristalline et la couche de nitrure que l'on réalise par coalescence de cristallites et qui forme une vignette. Cette couche intermédiaire forme typiquement la couche tampon.

Ainsi, la couche de fluage et la couche cristalline sont différentes. La couche de fluage présente une température de transition vitreuse. Elle est donc faite d'un matériau à transition vitreuse et présente le comportement des matériaux à transition vitreuse. Ainsi, la couche de fluage n'est pas cristalline. Elle est faite d'un matériau visqueux ou vitreux, par exemple d'un oxyde. La couche de fluage et la couche cristalline ne sont pas faites du même matériau.

Selon un exemple de réalisation, la couche de fluage présente une épaisseur $e_{220}$ inférieure à 500nm ($10^{-9}$ mètres). Elle est de préférence comprise entre 50 nm et 500 nm et de préférence entre 100 nm et 150 nm.

Selon un exemple de réalisation, la couche cristalline présente une épaisseur comprise entre 2 nm ($10^{-9}$ mètres) et 10 $\mu$m ($10^{-6}$ mètres) et de préférence entre 5nm et 500 nm et de préférence entre 10 nm et 50nm.

Selon un exemple de réalisation, on fait croitre par épitaxie des cristaux sur tous lesdits plots.

Selon un exemple de réalisation, le rapport V/III des flux dans le réacteur de dépôt par épitaxie (les flux étant par exemple mesurés en sccm) dudit matériau comprenant du nitrure (N) et au moins l'un parmi le gallium (Ga), l'indium (In) et l'aluminium (Al) est de l'ordre de 2000.

Selon un exemple de réalisation, le nitrure des vignettes est en nitrure de gallium (GaN). Selon un autre mode de réalisation, le nitrure des vignettes est à base de nitrure de gallium (GaN) et comprend en outre de l'aluminium (Al) et/ou de l'indium (In).

Selon un autre mode de réalisation, le matériau formant le nitrure (N) des vignettes est l'un quelconque parmi: le nitrure de gallium (GaN), le nitrure d'indium (InN), le nitrure d'aluminium (AIN), le nitrure d'aluminium gallium (AIGaN), le nitrure d'indium gallium (InGaN), le nitrure d'aluminium gallium indium (AIGaInN), le nitrure d'aluminium indium (AIInN), le nitrure d'aluminium indium Gallium (AIInGaN).

Selon un exemple, l'étape de formation des plots comprend la gravure de la couche cristalline et la gravure d'une portion seulement de la couche de fluage de manière à conserver une portion de la couche de fluage entre les plots.

Selon un exemple, l'étape de formation des plots est effectuée de sorte que $d_{cristallite}$/ $d_{plot} \geq$ k3, avec k3=3, $d_{plot}$ étant la dimension maximale de la section du plot prise dans une direction parallèle à un plan (xy) dans lequel s'étend principalement une face supérieure du substrat (plot ou plus généralement la distance bord à bord du plot, c'est-à-dire la dimension maximale du plot quelle que soit la forme de sa section), $d_{cristallite}$ correspondant à la dimension de la cristallite mesurée selon la même direction que $d_{plot}$ au moment de la coalescence des cristallites.

Des résultats particulièrement efficaces ont été obtenus pour k3 = 3. Selon un exemple 100$\geq$ k3 $\geq$ 3. De préférence, 50$\geq$ k3 $\geq$ 3. De préférence, 5$\geq$ k3 $\geq$ 3.

Cette caractéristique permet aux tronçons de fluage de se déformer pour encaisser de manière particulièrement efficace les contraintes mécaniques qui naissent lorsque deux cristallites adjacentes commencent à coalescer. Ainsi, cette caractéristique contribue efficacement à réduire la densité de défauts au sein des vignettes de nitrure que l'on obtient au final.

De préférence, $P_{plot}/d_{plot} \geq$ 4, et de préférence $P_{plot}/d_{plot} \geq$ 5. Selon un exemple qui donne des résultats particulièrement qualitatifs, $P_{plot}/d_{plot}$ = 5.

De préférence, $H/d_{plot} \geq$ 2. Ce rapport permet le mécanisme de relaxation de contrainte s'effectue en craquant les plots.

Selon un exemple, après ladite formation des plots, et avant ladite croissance par épitaxie des cristallites, on effectue une étape d'amincissement des tronçons de fluage. Cette étape d'amincissement comprend une gravure sélective des tronçons de fluage vis à vis d'au moins les tronçons cristallins. Ainsi, à l'issue de cette étape d'amincissement la section des tronçons de fluage se trouve réduite. Néanmoins, la section restante des tronçons de fluage suffit à supporter le tronçon cristallin, ainsi que les éventuels tronçons formés par les couches tampon et d'amorçage, ainsi que les cristallites qui seront formés par épitaxie. Ce mode de réalisation optionnel permet de relâcher les contraintes sur le procédé lors de la formation des plots, tout en favorisant la déformation des plots par fluage lors de la coalescence des cristallites.

Selon un exemple, le procédé comprend une étape de formation d'une couche barrière sur les vignettes de nitrure, puis une étape de formation d'au moins une source, d'un drain et d'une grille sur la couche barrière. Cela permet de former un transistor vertical, de préférence de type HEMT à partir de chaque vignette. La couche de nitrure, typiquement du GaN, d'un tel transistor peut présenter une épaisseur importante avec un taux de dislocations faible et sans entraîner de déformation du substrat.

De préférence, la couche barrière est faite ou est à base d'AlGaN. De préférence la couche barrière est formée par épitaxie. Le transistor peut comprendre d'autres couches entre la vignette de nitrure et la couche barrière.

Le terme « micro-LED » désigne une LED dont au moins une dimension prise dans un plan parallèle au plan principal dans lequel s'étend le substrat supportant la micro-LED (i.e., le plan xy du repère orthogonal référencé sur les figures) est micrométrique, c'est-à-dire strictement inférieure à 1 mm ($10^{-3}$ mètres). Dans le cadre de l'invention les micro-LED présentent, en projection dans un plan d'extension principal parallèle aux faces principales des micro-LED, i.e., parallèle à une face supérieure du substrat, des dimensions maximales de dimension micrométrique dans le plan. De préférence ces dimensions maximales sont inférieures à quelques centaines de micromètres. De préférence ces dimensions maximales sont inférieures à $500\,\mu$m.

Dans la présente invention, on entend par « transistors de type HEMT » (acronyme anglais de « High Electron Mobility Transistor ») des transistors à effet de champ à haute mobilité d'électrons, parfois également désignés par le terme de transistor à effet de champ à hétérostructure. Un tel transistor inclut la superposition de deux couches semiconductrices ayant des bandes interdites différentes qui forment un puit quantique à leur interface. Des électrons sont confinés dans ce puits quantique pour former un gaz bidimensionnel d'électrons. Pour des raisons de tenue en haute tension et en température, les matériaux de ces transistors sont choisis de façon à présenter une large bande d'énergie interdite.

Dans la suite de la description, les termes cristaux et cristallites seront considérés comme équivalents.

Il est précisé que dans le cadre de la présente invention, les termes « sur », « surmonte », « recouvre » ou « sous-jacent » ou leurs équivalents ne signifient pas « au contact de ». Ainsi par exemple, « le dépôt d'une première couche sur une deuxième couche » ne signifie pas obligatoirement que les deux couches sont directement au contact l'une de l'autre mais cela signifie que la première couche recouvre au moins partiellement la deuxième couche en étant soit directement à son contact soit en étant séparée d'elle par au moins une autre couche ou au moins un autre élément y compris de l'air. De même, « un plot surmontant une première couche » ne signifie pas que le plot est nécessairement au contact de cette première couche mais signifie que le plot est soit au contact de cette première couche soit au contact d'une ou plusieurs couches disposées entre la première couche et le plot.

Les étapes de formation des différentes couches et régions s'entendent au sens large : elles peuvent être réalisées en plusieurs sous-étapes qui ne sont pas forcément strictement successives.

Dans la description qui suit, l'épaisseur ou la hauteur est prise selon une direction perpendiculaire aux faces principales des différentes couches. Sur les figures, l'épaisseur ou la hauteur est prise selon la verticale ou selon l'axe z du repère orthogonal illustré en figure 3A.

De même lorsqu'on indique qu'un élément est situé au droit d'un autre élément, cela signifie que ces deux éléments sont situés tous deux sur une même ligne perpendiculaire au plan principal du substrat, soit sur une même ligne orientée verticalement (axe z) sur les figures.

On entend par un substrat, une couche, un dispositif, « à base » d'un matériau M, un substrat, une couche, un dispositif comprenant ce matériau M uniquement ou ce matériau M et éventuellement d'autres matériaux, par exemple des éléments d'alliage, des impuretés ou des éléments dopants.

Les termes « sensiblement », « environ », « de l'ordre de » signifient « à 10% près » ou, lorsqu'il s'agit d'une orientation angulaire, « à 10° près ». Ainsi, une direction sensiblement normale à un plan signifie une direction présentant un angle de $90\pm10°$ par rapport au plan.

Un exemple de procédé de formation d'une pluralité de vignettes selon l'invention va maintenant être décrit en référence aux **figures 3A à 3F.**

Comme illustré en **figure 3A**, on fournit un empilement comprenant au moins un substrat 100, surmonté successivement d'une couche de fluage 200 et d'une couche cristalline de 300. Ainsi la couche de fluage 200 est disposée entre le substrat 100 et la couche cristalline de 300.

Selon un exemple de réalisation le substrat 100 est à base de silicium, amorphe ou cristallin. Il assure la tenue mécanique de l'empilement.

La couche cristalline 300 présente une face inférieure en regard de la couche de fluage 200 et une face supérieure dont la fonction est de servir de couche de base pour faire croître par épitaxie le nitrure des vignettes 550A, 550B que l'on souhaite obtenir au final. Par exemple, la couche que l'on souhaite obtenir au final est une couche de nitrure de gallium GaN. Selon un exemple de réalisation, la couche cristalline 300 est à base de silicium monocristallin. Alternativement la couche cristalline 300 peut être à base de SiC ou de Al$_2$O$_3$.

De préférence, la couche de fluage 200 est faite d'un matériau visqueux. La couche de fluage 200, présente une température de transition vitreuse. Elle présente donc une transition vitreuse et présente le comportement des matériaux à transition vitreuse. Comme tous les matériaux présentant une température de transition vitreuse, la couche de fluage 200 sous l'effet d'une élévation de température, se déforme sans rompre et sans reprendre sa position initiale après une baisse de température. Au contraire, la couche cristalline 300 ne présente naturellement pas de transition vitreuse. La couche cristalline se déforme, puis se disloque et peut rompre. Par conséquent, la couche de fluage 200 et la couche cristalline 300 sont différentes. La couche de fluage 200 n'est pas cristalline.

La couche fluage 200 est faite d'un matériau amorphe tel qu'un oxyde, de préférence un oxyde de silicium SixOy, tel que le SiO2. Le rôle de cette couche sera explicité dans la suite de la description.

De manière avantageuse mais non limitative, cet empilement comprenant le substrat 100, la couche de fluage 200 et la couche cristalline 300 constitue un substrat de type semi-conducteur sur isolant, de préférence silicium sur isolant (SOI). Dans ce cas, la couche de fluage 200 est formée par la couche d'oxyde enterré (BOX) du substrat SOI.

Selon un exemple de réalisation avantageux illustré en **figure 3A**, on dépose, par épitaxie sur la face supérieure de la couche cristalline 300, une couche tampon 400. Lorsque les vignettes 550A, 550B que l'on souhaite obtenir au final sont formées de GaN et que la couche cristalline 300 est une couche à base de silicium, cette couche tampon 400 est typiquement en nitrure d'aluminium (AIN). Cela permet d'éviter le phénomène dit de «Melt-back etching» (gravure par refusion), généré par la très forte réactivité entre le silicium et le gallium aux températures usuelles d'épitaxie (1000/1100°C) et qui conduit à dégrader très fortement la vignette 550A, 550B de GaN.

Typiquement, l'épaisseur de la couche d'AIN est comprise entre 10 et 200 nanomètres (10$^{-9}$ mètres).

Comme illustré en **figure 3B**, on peut également déposer par épitaxie, sur la face supérieure de la couche tampon 400, une couche d'amorçage 500. Cette couche d'amorçage 500 a pour fonction de faciliter la reprise de croissance des cristallites 510 lors des étapes suivantes. Dans ce cas, c'est à partir d'une face supérieure de la couche d'amorçage 500 que se produit en partie au moins la croissance par épitaxie des cristallites 510A-510B4, les cristallites étant illustrées en figure 3D. Cette couche d'amorçage 500 est de préférence réalisée dans le même matériau que celui des vignettes 550A, 550B que l'on souhaite obtenir au final. Typiquement, lorsque le matériau des vignettes 550A, 550B est du nitrure de gallium GaN, la couche d'amorçage 500 est également en GaN. Cette couche d'amorçage 500 présente typiquement une épaisseur comprise entre 50 et 200 nanomètres.

Par souci de concision et de clarté, seuls quatre plots 1000A1-1000A4 sont représentés sur les figures pour supporter une vignette 550A. Naturellement, une vignette 550A peut être formée sur un nombre supérieur de plots. Comme cela sera décrit par la suite, le nombre de plots ainsi que leur période sera adaptée en fonction de la taille voulue pour la micro-LED.

On notera que les couches 400 et 500 sont uniquement optionnelles. Ainsi, selon des modes de réalisation non illustrés en figure 3A-3F, on pourra prévoir uniquement la couche tampon 400 ou uniquement la couche d'amorçage 500, ou encore aucune de ces deux couches 400 et 500.

Comme illustré en **figure 3C**, on forme ensuite des plots 1000A1-1000B4 à partir de l'empilement. Ces plots sont obtenus par gravure de l'empilement jusque dans la couche de fluage 200, une partie au moins de la gravure s'étendant au sein de la couche de fluage 200.

Pour former les plots par gravure, on pourra recourir aux nombreuses techniques de gravure connues de l'homme du métier. On pourra notamment utiliser les techniques classiques de lithographie, telles que les techniques de photolithographie comprenant la formation d'un masque, par exemple en résine, puis le transfert des motifs du masque dans l'empilement. On pourra également recourir aux techniques de lithographie par faisceau d'électrons (e-beam) ou aux techniques d'impression nanométrique.

Ces plots 1000A1-1000B4 sont de faibles dimensions et peuvent être qualifiés de nano-plots. Typiquement, la dimension maximale de la section des plots, prise dans un plan parallèle au plan xy du repère orthogonal xyz ou au plan de la face supérieure 101 du substrat 100, est comprise entre quelques dizaines et quelques centaines de nano-mètres. Plus précisément d$_{plot}$ est comprise entre 10 et 500 nanomètres et de préférence entre 20 et 150 nm et de préférence entre 50 et 100 nm par exemple de l'ordre de 50nm ou de 100 nm. Cette dimension maximale de la section des plots est référencée d$_{plot}$ en figure 3C. Si les plots sont de sections circulaires, cette dimension maximale d$_{plot}$ correspond au diamètre des plots. Si les plots sont de section hexagonale, cette dimension maximale d$_{plot}$ correspond à la diagonale ou au diamètre du cercle passant par les angles de l'hexagone. Si ces plots sont de section rectangulaire ou carrée cette dimension maximale d$_{plot}$ correspond à la plus grande diagonale.

Les plots 1000A1-1000B4 ne sont pas tous répartis de manière régulière à la surface du substrat 100. Les plots 1000A1-1000B4 forment des ensembles 1000A, 1000B de plots, chaque ensemble comprenant une pluralité de plots. Les plots 1000A1-1000A4 formant un même ensemble 1000A forment un réseau de plots distant du réseau de plots 1000B1-1000B4 formant un autre ensemble 1000B.

Ainsi, les plots adjacents 1000A1-1000A4 d'un même ensemble 1000A sont distants d'une distance D. Les plots adjacents 1000A4-1000B1 appartenant à deux ensembles 1000A, 1000B distincts sont séparés d'une distance W1. Les distances D et W1 sont prises dans des plans parallèles au plan xy et sont illustrées en figure 3C. Comme cela sera expliqué par la suite, les plots 1000A1-1000A4 d'un même ensemble 1000A sont destinés à supporter une unique vignette 550A qui sera distante d'une autre vignette 550B supportée par un autre ensemble 1000B de plots 1000B1-1000B4.

On notera que pour une même vignette, D peut varier. Ainsi, les plots 1000A1-1000A4 d'une même vignette 550A peuvent être répartis de manière non périodique. Leur répartition peut ainsi être adaptée pour favoriser la croissance de la vignette. Par exemple, si l'agencement des plots 1000A1-1000A4 d'une vignette 550A n'est pas périodique, on peut avoir une distance D qui varie pour ces plots 1000A1-1000A4 de plus ou moins 20 ou de plus ou moins 10 % par exemple plus ou moins 10 nm autour d'une valeur moyenne. Selon un exemple, D peut prendre les valeurs suivantes pour une même vignette : 100nm, 90nm, 85nm, 107nm.

Les vignettes 550A, 550B formées sur des ensembles de plots 1000A, 1000B répartis de manière non périodique peuvent quant à elles être disposées de manière périodique sur le substrat. Cela facilite la réalisation d'un micro écran.

Selon un exemple de réalisation, les tronçons des plots 1000A1-1000B4, formés dans la couche de fluage 200, présentent une hauteur e220 et, au sein d'un même ensemble, deux plots adjacents 1000A1, 1000A2 sont distants d'une distance D, telle que :

$e220 / D < 1$ , et de préférence $e220 / D < 1.5$. De préférence $e220 / D < 2$.

Selon un exemple de réalisation, les plots présentent une hauteur $H_{plot}$ et deux plots adjacents sont distants d'une distance D, telle que :

$H_{plot} / D < 2$ , et de préférence $H_{plot} / D < 1.5$. De préférence $H_{plot} / D \leq 1$.

$H_{plot}$ et e220 sont mesurées selon la direction z. D est mesurée parallèlement au plan xy.

Comme illustré en **figure 3C**, les plots sont gravés à travers toute la couche d'amorçage 500, toute la couche tampon 400 (lorsque ces dernières sont présentes), toute la couche cristalline 300. De préférence, seule une portion 220 de la couche de fluage 200 est gravée. Ce mode de réalisation présente pour avantage d'éviter que lors de l'épitaxie le nitrure des vignettes 550A, 550B se développe sur les tronçons de fluage 220. Cette sélectivité de l'épitaxie se rencontre notamment lorsque la vignette 550A, 550B de nitrure que l'on fait croître par épitaxie est du GaN et que les tronçons de fluage sont en SiO2. Au contraire, si, avec ces mêmes matériaux, la couche de fluage 200 est gravée sur toute son épaisseur, alors, lors de l'épitaxie, le nitrure des vignettes 550A, 550B se développe à partir de la face supérieure du substrat 100, habituellement formée de silicium. Cette situation n'est évidemment pas souhaitable.

Par ailleurs, il a été observé que le fait de conserver une portion 210 non gravée de la couche de fluage 200 permet de faciliter le fluage du tronçon 220, en particulier lorsque les cristallites sont désorientés en twist, c'est-à-dire dans des plans principaux d'extension des vignettes 550A, 550B que l'on souhaite obtenir. Ces plans principaux d'extension des vignettes 550A, 550B sont parallèles au plan xy du repère xyz.

De manière préférée, l'épaisseur e220 gravée, et formant donc la hauteur du tronçon de fluage 220, est égale à la moitié de l'épaisseur de la couche fluage 200. Cela permet d'avoir une très bonne réorientation des cristallites lors de la formation de joints de grains.

La **figure 3D** illustre la formation de cristallites 510A1-510B4 par croissance épitaxiale à partir de la couche d'amorçage 500 (ou de la face supérieure de la couche cristalline 300 lorsque les couches 400 et 500 sont absentes).

Comme illustré sur cette figure 3D, les plots 1000A1-1000B4 supportent chacun une cristallite 510A1-510B4 portée par un empilement de tronçons 400A1-400B4, 300A1-300B4, 220A1-220B4. Les tronçons s'étendent selon la direction principale d'extension du plot, c'est-à-dire verticalement (z) sur les figures 3A à 3F.

Les tronçons forment des cylindres circulaires si la section des plots est principalement circulaire. Si la section des plots 1000A1-1000B4 est polygonale, par exemple hexagonale, les tronçons forment alors des cylindres de section hexagonale. De préférence, les tronçons sont pleins. La section des plots est prise parallèlement au plan xy, soit parallèlement aux plans dans lesquels la couche fluage 220 et la couche cristalline 300 s'étendent principalement.

Quel que soit le mode de réalisation retenu, c'est-à-dire avec ou sans couche d'amorçage 400 et avec ou sans couche tampon 500, la croissance par épitaxie des cristallites 510A1-510B4, s'effectue en partie au moins ou uniquement à partir de la face supérieure 1001 du plot 1000A1-1000B4. Ainsi, cette face supérieure 1001 est formée soit par le tronçon cristallin 300A1-300B4, soit par le tronçon formé par la couche d'amorçage 400A1-400B4, soit par le tronçon formé par la couche tampon. Cela permet notamment d'obtenir rapidement des cristallites 510A1-510B4 d'épaisseur importante.

On remarquera que les faces supérieures de la couche tampon 400 et de la couche d'amorçage 500, c'est-à-dire les faces tournées au regard de la couche des vignettes 550A, 550B que l'on souhaite faire croître, présentent des polarités de type Gallium (Ga), et non pas azote (N), ce qui facilite considérablement l'obtention de vignettes 550A, 550B de nitrure épitaxiées de grande qualité.

La croissance des cristallites 510A1-510B4 se poursuit et s'étend latéralement, en particulier selon des plans parallèles au plan xy. Les cristallites 510A1-510B4 d'un même ensemble 1000A de plots 1000A1-1000A4 se développent jusqu'à coalescer et former un bloc ou vignette 550A, 550B comme illustré en **figure 3E**.

Autrement dit, et comme cela ressort clairement des figures, chaque vignette 550A, 550B s'étend entre plusieurs plots 1000A1-1000A4. Chaque vignette 550A, 550B forme une couche continue.

Cette croissance des cristallites 510A1-510B4 ne s'étend pas vers le bas. Par ailleurs, cette croissance est sélective en ce qu'elle n'a pas lieu sur la couche de fluage 200 typiquement faite d'un oxyde. En ce sens, la croissance des cristallites 510A1-510B4 s'effectue selon le principe de pendeo-épitaxie.

On notera qu'il est particulièrement avantageux de graver les plots 1000A1-1000B4 après formation par épitaxie de la couche tampon 400 et de la couche d'amorçage 500 (lorsque ces couches sont présentes). En effet, si l'une de ces couches 400, 500 était déposée après gravure, elle se formerait en partie au moins entre les plots 1000A1-1000B4 sur la face supérieure de la couche de fluage 200. Dans le cas où le nitrure épitaxié est du GaN, que la couche de fluage 200 est du SiO2, alors, à la température du dépôt par épitaxie, la croissance épitaxiale des vignettes 550A, 550B de nitrure ne s'effectuerait pas de manière sélective mais aurait au contraire également lieu entre les plots 1000A1-1000B4, ce qui naturellement n'est pas souhaitable.

De manière particulièrement avantageuse, la température $T_{épitaxie}$ à laquelle on effectue l'épitaxie est supérieure ou de l'ordre de la température $T_{transition\ vitreuse}$ de transition vitreuse de la couche de fluage 200. Ainsi, lors de l'épitaxie, les tronçons de fluage 220A1-220A4 sont portés à une température qui leur permet de se déformer.

Par conséquent, si les cristallites 510A11-510A12 portées par deux plots 1000A1-1000A2 adjacents sont désorientées l'une par rapport à l'autre, lors de la coalescence de ces deux cristallites, le joint 560 formé à leur interface, habituellement désigné joint de grains ou joint de coalescence, se formera sans dislocation pour rattraper ces désorientations. La déformation des tronçons de fluage 220 permet ainsi de rattraper ces désorientations et d'obtenir des vignettes 550A, 550B sans ou avec très peu de dislocations aux joints de coalescence. Ce phénomène sera décrit en détail par la suite en référence aux figures 5A à 5D.

Ainsi, à l'issue de l'étape 3E, on obtient une pluralité de vignettes 550A, 550B, chaque vignette 550A étant supportée par les plots 1000A1-1000A4 d'un même ensemble 1000A de plots. Deux vignettes adjacentes 550A, 550B sont séparées d'une distance W2, W2 étant la distance la plus faible prise entre ces deux vignettes. W2 est mesurée dans le plan xy.

W2 dépend de W1, de la durée et de la vitesse de la croissance épitaxiale. W2 est non nulle. W2 < W1.

On note $d_{vignette}$ la dimension maximale d'une vignette mesurée parallèlement au plan xy. Ainsi, $d_{vignette}$ correspond à la dimension maximale d'une projection de la vignette dans un plan parallèle au plan xy. De préférence 0.8 $\mu$m $\leq d_{vignette} \leq 3$ $\mu$m et de préférence 1 $\mu$m $\leq d_{vinette} \leq 2$ $\mu$m. $d_{vinette}$ dépend de la vitesse et de la durée de la croissance épitaxiale ainsi que du nombre, de la dimension et du pas $p_{plot}$ des plots d'un même ensemble.

Le procédé de réalisation des vignettes 550A,550B peut être stoppé à l'issue de la figure 3E. Alternativement, ce procédé peut être poursuivi pour former une micro-LED à partir de chacune des vignettes 550A,550B.

La figure 3F illustre un mode de réalisation non limitatif dans lequel on réalise des puits quantiques 590 au sein de chaque vignette 550A,550B. Ce mode de réalisation permet avantageusement de réaliser directement une micro-LED de taille correspondant à la taille initiale de la vignette. Pour réaliser des puits quantiques 590 au sein de chaque vignette 550A,550B, l'homme du métier pourra mettre en oeuvre les solutions connues de l'état de la technique. Ainsi, une fois que les cristallites 510 ont coalescé, on adopte les mêmes conditions de croissance pour les puits que lors d'une croissance bidimensionnelle classique.

La plus faible dimension possible pour les micro-LED est fonction de la résolution ultime des méthodes de structuration choisies : par exemple, pour des réseaux élaborés par nanoimpression, on atteint des tailles de plots de 50 nm et des périodes $p_{plot}$ de 150 à 200nm. Ce qui signifie que l'on obtient des dimensions $d_{vinette}$ de vignettes de 1 à 2 $\mu$m. Ceci est donc de l'ordre des tailles de pixels recherchées pour les $\mu$-display haute résolution.

La figure 4A est une photo obtenue par microscopie électronique à balayage ( MEB) montrant un substrat supportant une pluralité de vignettes 550A, 550B obtenues avec le procédé décrit ci-dessus.

La figure 4B est une photo obtenue par microscopie électronique à balayage (MEB), dont l'agrandissement est supérieur à celle de la figure 4, et montrant une vignette 550A. La face supérieure de la vignette de cette figure 4B présente une forme carrée. La longueur de chaque côté est de 300 $\mu$m. Les plots présentent une section que l'on peut assimiler à un carré dans le côté mesure 200nm.

La figure 4C est une photo d'une autre vignette 550A. La face supérieure de cette vignette présente, en projection dans le plan xy, une forme hexagonale ou sensiblement rectangulaire. En considérant cette forme comme rectangulaire, les longueurs de deux côtés adjacents sont 40 et 50 $\mu$m. La surface de la vignette étant alors de $40\mu$m $\times$ $50\mu$m.

La figure 4D est une photo d'une autre vignette 550A. La face supérieure de cette vignette présente, en projection dans le plan xy, une forme hexagonale ou sensiblement rectangulaire. On considérant cette forme comme rectangulaire, les longueurs de deux côtés adjacents sont 3 et $4\mu$m. La surface de la vignette étant alors de $3\mu$m $\times$ $4\mu$m.

Dans ces exemples, il s'agit de vignettes de GaN obtenues à partir d'un réseau de plots gravés dans un empilement GaN sur SOI.

Ces figures 4A à 4D montrent qu'il est possible de réaliser des vignettes 550A de quelques dizaines à quelques

centaines de $\mu$m en mettant en oeuvre le procédé décrit ci-dessus. La densité de dislocations dans ces vignettes de GaN est de l'ordre de 1 à 2 $10^E8$ / cm$^2$. L'efficacité radiative des puits quantiques est très bonne. Un écran comprenant une pluralité de LEDs formées à partir de ces vignettes présentes une haute résolution et une forte brillance.

Modélisation et explication du principe de coalescence sans ou avec peu de dislocation au sein des vignettes

Comme indiqué ci-dessus en référence à la figure 3E, si les cristallites 510A11-510A12 portées par deux plots 1000A1-1000A2 adjacents sont désorientées l'une par rapport à l'autre, lors de la coalescence de ces deux cristallites, le joint 560 formé à leur interface se formera sans dislocation en rattrapant ces désorientations. La déformation des tronçons de fluage 220 tel que proposé par la présente invention permet ainsi de rattraper ces désorientations. Ce principe est expliqué dans les paragraphes qui suivent.

Tel qu'illustré en **figures 5A et 5B**, la désorientation des deux cristallites adjacentes 510A1-510A12 peut résulter d'un défaut d'alignement dans le plan (c'est-à-dire autour d'axes contenus dans le plan des figures 3A-3F), on parle alors de twist.

La figure 5A, qui présente une vue du dessus des cristallites 510A1-510A2, illustre ce type de défaut d'alignement avec la présence d'un angle $\alpha$ entre les cristallites. Cette figure 5A illustre de manière schématique que, avec les procédés classiques de formation par épitaxie des couches de nitrure, le joint 560 qui se forme lors de la coalescence donne naissance à des dislocations 561 pour rattraper les défauts d'alignement.

Plusieurs raisons expliquent la présence de dislocations avec les procédés connus de réalisation d'une couche de nitrure.

Une première raison est que la croissance épitaxiale de la couche de nitrure est réalisée sur des hétéro-substrats, c'est-à-dire sur des substrats dont le matériau et donc les paramètres de maille sont différents de ceux de la couche de nitrure que l'on veut épitaxier.

Une deuxième raison qui explique la présence de dislocations est que la croissance épitaxiale s'effectue de manière colonnaire. Ceci est lié principalement à la diffusivité faible des espèces en surface de l'hétéro-substrat pendant la croissance, ce qui se traduit par la formation de grains de taille réduite. Lors de la coalescence, ces grains se joignent en formant à leur interface, c'est-à-dire au niveau du joint de coalescence, des dislocations qui traversent ensuite toute la structure épitaxiée.

Pour des raisons de cout et de disponibilité avec des dimensions compatibles avec les contraintes industrielles il n'est pas envisageable de recourir à des substrats de même nature que les couches que l'on veut épitaxier (homo-substrats).

Les solutions industrielles reposent donc sur l'utilisation d'hétéro-substrats. Cependant lorsque l'on utilise des hétérosubstrats, de nombreuses dislocations sont générées dans les couches épitaxiées et ces défauts se propagent jusque dans les zones actives du dispositif.

Une solution pour réduire la densité de dislocations consiste à recourir à des méthodes dites de « recroissance latérale » ou ELOG, acronyme de l'anglais « epitaxial lateral overgrowth ». Le principe de cette méthode repose sur le fait qu'à un certain stade de la croissance épitaxiale, on procède au dépôt d'un masque présentant des ouvertures. Les germes de croissance croissent dans les ouvertures puis au-dessus du masque par recroissance latérale. La recroissance latérale se traduit par la courbure des dislocations issues des germes, ce qui évite donc leur propagation verticale. Ce type de procédé permet donc d'éliminer un grand nombre de dislocations par courbure, mais des dislocations sont aussi créées à la coalescence. En effet lorsque deux cristallites issues de deux ouvertures adjacentes se joignent au-dessus du masque, il se forme un joint de coalescence et la dislocation peut atteindre la surface.

En pratique, si on constate bien que les dislocations sous le masque sont effectivement bloquées, les dislocations qui arrivent à se propager au travers des ouvertures du masque se propagent dans la couche épitaxiée et peuvent atteindre la surface.

Bien sûr, la densité de dislocations traversantes issues de la coalescence est fortement réduite par rapport à ce qu'elle est dans le cas de la coalescence « naturelle », puisque les « grains » sont de dimensions plus importantes (typiquement de l'ordre de la période des ouvertures dans le masque). Mais ces dislocations sont distribuées de façon non uniforme, ce qui peut poser problème lors de la fabrication des dispositifs, puisque résultant de la formation de bandes de matériau non luminescent à l'aplomb de ces zones.

Une autre solution consiste à faire recroître par épitaxie du matériau sur des plots préexistants de ce matériau: il s'agit du procédé dit de pendeo-épitaxie qui permet de s'affranchir de la recroissance sur le masque. En revanche, les solutions connues de pendeo-épitaxie ne permettent pas d'éliminer voire de réduire significativement l'apparition de défauts générés par la coalescence de germes adjacents.

La figure 5B illustre de manière très schématique la formation du joint de coalescence 560 en mettant en oeuvre le procédé décrit ci-dessus. Cette figure 5B fait apparaître la déformation en torsion TA1, TA2 (autour de l'axe z) des tronçons de fluage permettant de former un joint de coalescence 560 sans dislocation. Dans ce cas, le rattrapage de cette déformation par les tronçons de fluage 220a-220b conduit à une torsion des tronçons de fluage 220A1-220A2 autour de leur axe principal. Chaque tronçon tourne dans un sens opposé comme illustré sur la vue de droite de la figure 5B.

Comme illustré en **figures 5C et 5D**, le défaut d'orientation des deux cristallites adjacentes 510A1, 510A2 peut également résulter d'un défaut d'alignement hors du plan (c'est-à-dire autour d'axes parallèles à l'axe y ou à l'axe x du repère xyz), on parle alors de tilt. Dans ce cas, le rattrapage de cette déformation par les tronçons de fluage 220A1-220A2 conduit à une inclinaison des plots.

La figure 5C illustre par l'angle β le défaut d'orientation angulaire entre les plans cristallins des cristallites 510A1 et 510A2 avant coalescence. La figure 5D illustre de manière très schématique la déformation du tronçon de fluage 220 permettant de former un joint de coalescence 560 sans dislocation. On a supposé dans ce schéma que la désorientation est répartie de façon égale entre les deux cristallites 510A1 et 510A2, soit de β 12. Le schéma est aussi applicable dans le cas où les désorientations cristallines sont différentes en angle dans les deux cristallites adjacentes et dont la somme est égale à β.

Les figures 5A à 5D n'ont pas pour objectif de donner une représentation visuelle proche de la réalité concernant la déformation des tronçons du fluage. Ces figures visent à donner une représentation schématique pour comprendre facilement le principe de coalescence des cristallites sans dislocation au niveau des joints 560. Les paragraphes qui suivent visent à donner des explications et précisions additionnelles concernant ce principe.

Les paragraphes ci-dessous visent à expliquer de manière plus précise les phénomènes qui permettent d'obtenir une couche ou une vignette 550A, 550B épitaxiée sans ou avec très peu de dislocations.

Lorsque deux grains ou cristallites sont rigidement liés au substrat sur lesquels ils ont été déposés et sont légèrement désorientés l'un par rapport à l'autre, l'énergie de formation de leur joint de coalescence est élevée (on peut assez aisément en calculer l'énergie puisqu'il s'agit en première approximation d'un réseau de dislocations interfaciales. On pourra pour cela se référer à la publication suivante : J.P.Hirth et J. Lothe "Theory of dislocations", John Wiley and sons (1982)).

En revanche, si les cristallites 510A1-510A4 reposent sur des plots 1000A1-1000A4 comme c'est le cas en pendeo-épitaxie, et que ces plots 1000A1-1000A4 peuvent se déformer, par torsion (twist) ou inclinaison (tilt), la désorientation des cristallites (par exemple de GaN) les unes par rapport aux autres est « transmise » aux plots portant ces cristallites. Dans le cas d'une simple torsion (twist), comme illustré en figure 5B, on peut modéliser le phénomène en disant que les forces attractives qui amènent les cristallites à effectuer une rotation pour se joindre et former une surface « interne » résultent en un couple de torsion au niveau des nano plots 1000A1-1000A4. Ce couple de torsion sera d'autant plus important que le rapport entre taille de plots 1000A1-1000A4 et taille des cristallites est petit. Si la déformation des plots 1000A1-1000A4 est facile, le joint de coalescence 560 se transforme alors simplement en une surface interne pour laquelle les liaisons atomiques « parfaites » seront formées. Energétiquement parlant, ceci ne sera possible que si l'énergie libérée à la coalescence par formation d'une « surface interne » est supérieure à l'énergie qu'il faut dépenser pour que les plots 1000A1-1000A4 eux-mêmes se déforment pour absorber les désorientations initiales entre les cristallites 510A1-510A2 adjacentes. Le fait que le plot sous-jacent soit un piédestal en $SiO_2$ est favorable puisque le $SiO_2$ flue à la température de croissance. Le $SiO_2$ est un matériau effectivement bien adapté pour ce procédé, mais ceci n'exclue pas l'utilisation de matériaux autres, tels que des verres qui peuvent fluer à des températures équivalentes ou plus basses, comme les verres en borosilicates ou les verres en borophosphosilicates (BPSG), utilisés également pour la fabrication du SOI.

Dans le cas des cristallites de GaN de forme hypothétiquement cubique et de 500 nm de côté, portées par des plots de section circulaire de diamètre 100 nm, l'énergie libérée à la coalescence peut s'exprimer comme la différence entre l'énergie de cohésion interne et les énergies de surface des deux surfaces qui seront mises en contact. Les valeurs d'énergie de surface sont de l'ordre de 0.1 à 0.2 eV/Angstrôm$^2$ (on pourra pour cela se référer à la publication suivante : C. E.Dreyer, A. Janotti, and C. G. Van de Walle "Absolute surface énergies of polar and nonpolar planes of GaN", PHYSICAL REVIEW B 89, 081305(R) 2014). Les énergies de cohésion sont quant à elles de l'ordre de 11eV (liaison Ga-N).

En première approximation, en partant d'une surface hexagonale (type 0001) on obtient une valeur de 36 eV par maille (trois liaisons Ga-N par maille), soit, pour la maille hexagonale considérée (surface 26 A$^2$), une énergie de cohésion rapportée à la surface de 1.35eV / Angstrom$^2$. Nous avons simplifié l'approche en considérant des surfaces à mettre en contact de type c (0001), mais les corrections liées à l'orientation cristalline de ces surfaces (nombre de liaisons par maille et énergies de surface) sont du deuxième ordre et ne modifient que peu cette évaluation numérique.

On trouve alors une énergie « libérée » (état final - état initial) à la mise en contact par formation de liaisons covalentes de 1.35-0.3 = 1.05, soit environ 1eV par Angström$^2$. Ceci est évidemment indépendant de la désorientation entre les cristallites 510A1, 510A2 à mettre en contact. Si l'on considère des cristallites de forme cubique (pour simplifier l'estimation comme sur les schémas en figure 2b) et de côté 500 nm, on trouve alors une énergie libérée de 25 $10^E6$ × 1,6 $10^E$-19, soit de l'ordre de 4 $10^E$-12 Joules. Ceci est à comparer à l'énergie nécessaire pour déformer les plots 1000A1-1000A4 en $SiO_2$ sous les cristallites comme nous allons le détailler ci-dessous.

A la température d'épitaxie du GaN (environ 1100°C), l'oxyde de silicium a un comportement visco-plastique avec une viscosité qui dépend à la fois de la température et de la contrainte mécanique subie par le matériau.

Lorsque la température augmente, la viscosité du SiO2 diminue, comme tout matériau ayant une transition vitreuse. Au-dessus d'une certaine contrainte, la viscosité du SiO2 diminue aussi lorsque la contrainte mécanique augmente. Autrement dit, contrairement à un fluide classique dans lequel la vitesse de déformation plastique est proportionnelle aux contraintes de cisaillement (viscosité indépendante de la contrainte), au-delà d'une valeur seuil qu'on appelle contrainte de rupture, la vitesse de déformation du SiO2 augmente exponentiellement avec la contrainte. En pratique, à 1100°C, la contrainte de rupture du SiO2 est de l'ordre de 500 MPa: à cette température, la viscosité du SiO2 est donc indépendante de la contrainte jusqu'à des contraintes de 500MPa. Au-delà, la viscosité chute de plusieurs ordres de grandeur et une déformation plastique très rapide laisse ensuite une contrainte résiduelle proche de la contrainte de rupture. Cette contrainte résiduelle diminue ensuite beaucoup plus lentement par fluage classique (plusieurs minutes à plusieurs heures).

Avant alignement, les cristallites 510A1-510A4 de GaN présentent une désorientation les unes par rapport aux autres d'en moyenne 1 à 6°. Avant que les cristallites voisines ne se soudent en formant des liaisons atomiques covalentes, les forces interatomiques agissant entre les cristallites sont les forces de Van der Waals qui sont attractives à très courte portée. Ceci se traduit par l'existence d'un couple de rotation appliqué au point de contact pour les aligner. Après une très faible rotation d'une fraction de degré, la contrainte de rupture de 500MPa est atteinte dans le tronçon de fluage 220A1-220B4 sous les plots 1000A1-1000A4. Le fluage devient alors quasiment instantané dans l'oxyde et le couple de rotation nécessaire à la rotation est constant pendant la fin de la phase d'alignement.

Si l'on reprend la géométrie de la figure 5B, i.e. une cristallite 510 de forme cubique de 500nm de côté et centrée sur un plot de section circulaire plus petit de 100nm de côté. La coalescence complète des cristallites 510A1-510A4 est effectuée en typiquement quelques centaines de secondes. Si nous prenons 1s comme temps caractéristique de la mise en contact des cristallites 510, un modèle numérique montre que pour tourner le plot de 2° en une seconde environ, il faut fournir un travail mécanique de l'ordre de $0.5^{E}$-20 à $1^{E}$-20 Joules, en tenant compte de la rupture de l'oxyde à haute température. L'énergie libérée par la mise en contact des deux surfaces, de l'ordre de $10^{E}$-11 à $10^{E}$-13 Joules est donc très nettement supérieure à l'énergie mécanique de déformation de plots 1000A1-1000A4 sous-jacents. Cette énergie est aussi plusieurs ordres de grandeur plus faible que celle qui aurait été nécessaire pour aligner des plots construits sur du silicium massif (bulk) ou pour aligner des plots formés par un matériau ne présentant pas de phase de transition vitreuse aux alentours de la température de croissance épitaxiale des cristallites 510A1-510A4.

Les considérations des paragraphes ci-dessus montrent que pour obtenir une coalescence des cristallites sans dislocation, on peut ajuster les paramètres suivants :

- Les propriétés de « rupture mécanique » du matériau formant le tronçon de fluage à haute température sous des contraintes relativement faibles de 500MPa.

- La taille suffisamment petite des plots 1000A1-1000A4 de support comparée à la distance D entre les plots d'un même ensemble 1000A, permet de créer une contrainte dans le tronçon de fluage qui soit, pour un couple de rotation donné, supérieure à la contrainte de rupture.

Par ailleurs, comme indiqué ci-dessus, on veillera à ce que la température d'épitaxie $T_{épitaxie}$ rende possible le fluage du tronçon de fluage 220. En pratique, $T_{épitaxie} \geq 600°C$ (dans le cadre d'une épitaxie par jets moléculaires), $T_{épitaxie} \geq 900°C$ et de préférence $T_{épitaxie} \geq 1000°C$ et de préférence $T_{épitaxie} \geq 1100°C$. Ces valeurs permettent de réduire de manière particulièrement efficace les défauts dans la vignette ou la couche épitaxiée lorsque la couche de fluage est en SiO2. En pratique, $T_{épitaxie} \leq 1500°C$.

Afin de faciliter la formation de joints de coalescence 560 sans dislocation, il sera préférable d'appliquer les conditions suivantes :
$T_{épitaxie} \geq k1 \times T_{transition\ vitreuse}$, avec k1 = 0.8, de préférence k1 = 1 et de préférence k1 = 1,5.

Selon un exemple de réalisation, $T_{épitaxie} \leq k2x\ T_{fusion\ min}$, $T_{fusion\ min}$ étant la température de fusion la plus faible parmi les températures de fusion des tronçons formant le plot. Il s'agit principalement du tronçon cristallin et du tronçon de fluage. Selon un exemple de réalisation, k2 = 0.9. Cela permet d'éviter une diffusion des espèces du matériau dont la température de fusion est la plus faible.

Ainsi, dans le cas où le plot est formé de tronçons de fluage en SiO2 et de tronçons cristallins en silicium, $T_{épitaxie} \leq 1296°C$. En effet, $T_{fusion\ min}$ est égale à la température de fusion du silicium puisque la température de fusion du silicium est égale à 1440° et la température de fusion du SiO2 est égale à 1970°C.

Selon un exemple de réalisation, la hauteur $e_{220}$ du tronçon de fluage est telle que $e220 \geq 0.1\ d_{plot}$. De préférence, $e220 \geq 1\ d_{plot}$. Ces valeurs, permettent d'obtenir une déformation suffisante pour réduire les contraintes au niveau du joint de grain.

Les plots 1000A1-1000A4 présentent une hauteur $H_{plot}$, et deux plots 1000A1-1000A2 adjacents sont distants d'une distance D, telle que : $H_{plot}/D < 2$ et de préférence $H_{plot}/D \leq 1$.

Avantageusement, l'étape de formation des plots 1000A1-1000A4 est effectuée de sorte que $d_{cristallite} / d_{plot} \geq$ k3, $d_{plot}$ étant la dimension maximale de la section du plot 1000A1-1000A4 prise dans une direction parallèle au plan dans lequel s'étend la face supérieure 110 substrat 100. Ainsi $d_{plot}$ correspond à la dimension maximale d'une projection du plot dans le plan xy. $d_{cristallite}$ correspond à la dimension de la cristallite mesurée selon la même direction que $d_{plot}$ au moment de la coalescence des cristallites 510A1-510B4. La dimension $d_{cristallite}$ est référencée en figure 3E.

Selon un exemple $100 \geq k3 \geq 1.1$. De préférence, $50 \geq k3 \geq 1.5$. De préférence, $5 \geq k3 \geq 2$.

Selon un exemple $k3 \geq 3$, de préférence $100 \geq k3 \geq 3$. De préférence, $50 \geq k3 \geq 3$. De préférence, $5 \geq k3 \geq 3$.

Cette caractéristique permet aux tronçons de fluage de se déformer pour encaisser de manière particulièrement efficace les contraintes mécaniques qui naissent lorsque deux cristallites adjacentes commencent à coalescer. Ainsi, cette caractéristique contribue efficacement à réduire la densité de défauts au sein de la vignette 550A, 550B de nitrure que l'on obtient au final.

**Mode de réalisation des figures 18A à 18C**

En référence aux figures 18A à 18C, un mode de réalisation alternatif va maintenant être décrit. Les étapes préalables à celle illustrée en figure 18A peuvent être identiques aux étapes illustrées en figures 3A à 3C. Ainsi, toutes les caractéristiques, étapes et effets techniques mentionnés en référence à ces figures 3A à 3C sont parfaitement applicables pour ce mode de réalisation alternatif.

À l'issue de l'étape illustrée en figure 3C, on effectue une étape d'amincissement des tronçons de fluage 220. Cette étape conduit à la réduction de la section des tronçons de fluage 220.

Avant amincissement la section des tronçons de fluage 220 correspond à $d_{plot}$, comme illustré en figures 3C et 18A. Après amincissement la section des tronçons de fluage 220 correspond à $d_{220A}$, comme illustré en figure 18A. L'épaisseur amincie est notée à $e_A$, comme illustré en figure 18A.

Pour effectuer cet amincissement, on prévoit une gravure qui grave le matériau du tronçon de fluage 220 sélectivement au matériau du tronçon cristallin 300, ainsi qu'aux tronçons formés respectivement par la couche tampon 400 et la couche d'amorçage 500 lorsque ces dernières sont présentes. On pourra par exemple utiliser une gravure humide à base d'une solution d'acide fluorhydrique (HF). Cette gravure est particulièrement efficace et sélective lorsque la couche de fluage 200 est faite d'un oxyde et que la couche cristalline 300 est à base de silicium.

Sur l'exemple illustré en figure 18A, les pointillés correspondent aux contours de la couche de fluage 200 avant gravure. Sur l'exemple non limitatif illustré en figure 18A, la portion 210 de la couche de fluage 200 est retirée entièrement. Ainsi, le substrat 100 est mis à nu. On notera qu'il est néanmoins préférable de conserver une partie de la portion 210. Ainsi, de préférence, une partie de la portion 210 recouvre le substrat 100. Cela favorise la déformation des tronçons de fluage 220 lors du fluage.

L'étape 18B correspond au début de la croissance épitaxiale des cristallites sur les plots 1000. Cette étape 18B correspond à l'étape 3D.

L'étape 18C correspond à la coalescence des cristallites sur les plots 1000, jusqu'à la formation d'une vignette 550A, 550B sur chaque ensemble 1000A, 1000B de plots. Cette étape 18C correspond à l'étape 3E.

Ainsi, toutes les caractéristiques, étapes et effets techniques mentionnés en référence aux figures 3D et 3E sont parfaitement applicables pour ce mode de réalisation alternatif illustré aux figures 18A à 18C.

Dans le cas non limitatif où l'on souhaite réaliser des LEDs, l'étape 18C peut être poursuivie en appliquant les caractéristiques et étapes décrites en référence à la figure 3F.

Ce mode de réalisation qui prévoit un amincissement de la portion de fluage présente plusieurs avantages.

En particulier, il permet de réaliser, avant la croissance épitaxiale des cristallites, des plots dont les tronçons de fluage présentent une section réduite. Cela permet de faciliter la déformation des plots lors du fluage provoqué par la température appliquée lors de la croissance épitaxiale. Ce mode de réalisation permet de réduire encore plus les contraintes lors de la coalescence des cristallites et donc de réduire le risque d'apparition de défauts et dislocations.

Ce mode de réalisation permet alors de former des plots 1000 dont :

- le tronçon cristallin, voire le tronçon formé par les couches tampon 400 et d'amorçage 500 6 s'ils sont présents, présentent des dimensions relativement importantes (ces dimensions sont mesurées dans un plan xy, parallèle aux faces principales du substrat 100). Cela permet de réduire les contraintes sur le procédé lors de la réalisation des plots 1000. On peut ainsi prévoir des dimensions supérieures aux dimensions $d_{plot}$ décrites ci-dessus.

- le tronçon de fluage 220 présente une plus faible section qui favorise la déformation et la bonne orientation des cristallites lors du fluage. On peut prévoir, pour la section du tronçon de fluage 220, une dimension $d_{220A}$ qui correspond aux valeurs numériques mentionnées ci-dessus à propos de $d_{plot}$.

Ainsi, ce procédé permet de réduire les contraintes sur le procédé tout en améliorant la qualité des vignettes 550A, 550B de nitrure obtenues.

Par exemple:

- au niveau du tronçon cristallin $d_{plot} \geq 100$ nm et de préférence $d_{plot} \geq 200$ nm et encore plus préférentiellement $d_{plot} \geq 500$ nm et de préférence $d_{plot} \geq 1000$ nm.

- au niveau du tronçon de fluage 220, 20 nm $\leq d_{220A} \leq 200$ nm et de préférence 50 nm $\leq d_{220A} \leq 100$ nm.

### Exemples de réalisation

En référence aux figures 6 à 10 plusieurs exemples de réalisation d'une vignette vont maintenant être décrits.

La **figure 6** est une photo prise au microscope électronique à balayage (MEB). Elle permet d'apercevoir un empilement comprenant successivement le substrat 100, la portion 210 de la couche de fluage non gravée, le tronçon de fluage 220, la couche cristalline 300 ainsi qu'une cristallite 510, ici de GaN. Cette cristallite 510 est de forme pyramidale en raison de la plus faible vitesse de croissance des plans semi-polaires qui forment les facettes de la pyramide. Dans cet exemple, le diamètre du plot est de 100 nm.

De part et d'autre du tronçon de fluage 220 on aperçoit des espaces 230 vides.

Pour assurer la coalescence des cristallites pyramidales et obtenir une croissance bidimensionnelle, il peut être avantageux de procéder de la manière suivante. Au cours d'une première étape on réalise des pyramides sur chacun des nano-plots en utilisant des conditions de croissance données jusqu'à ce que les pyramides se jouxtent. Au cours d'une seconde étape, on modifie ces conditions de croissance pour induire une croissance latérale. Cette procédure de croissance en deux étapes est par exemple décrite dans la publication suivante : Shields et AI. 2011, Nanopendeo coalescence overgrowth of GaN on etched nanorod array Phys. Status Solidi C 8, No. 7-8, 2334-2336 (2011).

Les figures **7A et 7B** donnent des exemples d'une vignette 550 formée par une couche de nitrure obtenue selon ce procédé pour une matrice de 197x300 plots. Dans cet exemple, la taille des plots est de 200 nm et leur pas est de 1 $\mu$m. Cette dimension de plot permet de réduire très significativement le nombre de dislocations apparaissant sur la cristallite d'un plot. Par ailleurs, cette taille de plot permet d'optimiser la déformation et la transmission du couple lors de la coalescence.

De manière particulièrement avantageuse, on observe clairement que la couche de nitrure formant la vignette 550 s'est désolidarisée du substrat 100 sous-jacent. La délamination de la vignette 550 que l'on souhaite obtenir au final est donc particulièrement aisée. Cette délamination automatique peut être complète ou partielle. Elle sera décrite plus en détail par la suite.

Il est ainsi possible de réaliser des vignettes auto-supportées de GaN, dans cet exemple de taille 300x300 $\mu$m.

Les figures **8A à 8C** sont des photos représentant, avec différents niveaux de grossissement et angles de vue, une matrice 580 de cristallites 510 de GaN formant des pyramides et obtenues après croissance sur les plots. La figure 8A est une photo de l'ensemble de la matrice 580, prise en perspective. Cette matrice 580 est carrée, et présente une surface de $40 \times 40 \mu m^2$. La figure 8B est une photo d'une partie de la matrice 580 en vue du dessus. La figure 8C est une photo d'une partie de la matrice 580 vue en perspective et faisant clairement apparaître les cristallites 510 supportées par les plots 1000 formés sur le substrat 100. Comme cela apparaît clairement en figure 8C, les cristallites 510 forment des pyramides de section hexagonale. Les plots ont été réalisés par lithographie par faisceau d'électron (e-beam) à partir d'un empilement comprenant les couches suivantes :

- couche de fluage 200 : SiO2
- couche cristalline 300 : Si
- couche-tampon 400 : AlN
- couche d'amorçage 500 : GaN

Sur l'exemple illustré en figures 8A à 8C, les plots peuvent par exemple avoir un diamètre de 200 nm et sont espacés de 1$\mu$m.

### Caractérisations des défauts de coalescence

La **figure 9** est une photo prise au microscope électronique en transmission (TEM) d'une coupe de cristaux 510 de GaN ayant coalescé. Sur cette figure, on remarque tout d'abord que la majeure partie des dislocations 560 issues de la re-croissance sont alignées dans le plan de croissance au démarrage de la croissance.

Par ailleurs il apparaît clairement que la coalescence des cristallites 510 issues de plots adjacents se fait avec très peu de défauts de coalescence au niveau du joint de coalescence 560. Ceci est à comparer aux méthodes classiques pour lesquelles la coalescence génère des défauts traversants. Ces méthodes classiques peuvent être basées sur une recroissance latérale illustrée en figure 11A et 11B et comme décrit dans la publication E.B Yakimov et A.Y Polyakov, 2015 Ebic investigation of dislocations in ELOG GaN, Phys. Status Solidi. Ces figures 11A et 11B montrent clairement qu'avec cette méthode les défauts 903 des couches de nucléation traversent toute la couche finale à travers les ouvertures 902 du masque 901.

Ces méthodes classiques peuvent aussi être basées sur une recroissance de type pendeo à partir de structures unidimensionnelles comme décrit dans la publication mentionnée ci-dessus Shields et AI. 2011, Nanopendeo coalescence overgrowth of GaN on etched nanorod array Phys. Status Solidi C 8, No. 7-8, 2334-2336 (2011).

On remarque également en figure 9 que les plots 1000A1, 1000A2, à la moitié de leur hauteur, sont fendus, ce qui permettra une délamination facile de la vignette épitaxiée 550 sur la matrice 580 des plots 1000A1-1000A2.

Cette caractéristique est très avantageuse dans le cas des vignettes que l'on veut pouvoir aisément détacher après report pour former des micro-LEDs.

La **figure 10** confirme l'absence de défauts à la coalescence entre deux cristallites, par exemple de forme pyramidale, en utilisant la technique de cathodoluminescence. Cette technique permet de réaliser une cartographie spatiale de l'émission de photons par le matériau considéré. L'image de cathodoluminescence panchromatique en figure 10 montre que, aux variations d'émission près liées à l'extraction de lumière issue des facettes différentes (ou des arrêtes), il n'y a pas au niveau du raccordement entre deux cristallites, des recombinaisons non radiatives, ce qui témoigne de l'absence de défauts de structure dans la région du joint de coalescence.

**Procédé de réalisation de micro-LED à partir d'une pluralité de vignettes**

En références aux figures 12A à 120, un exemple de procédé de réalisation de micro-LED 570A, 570B va maintenant être décrit.

Une première étape consiste à fournir un dispositif comprenant une pluralité de vignettes 550A, 550B de nitrure. Ce dispositif peut être identique à celui illustré en figure 3F. Il est par exemple obtenu en mettant en oeuvre le procédé décrit en référence aux figures 3A à 3F. Ainsi, chacune des vignettes 550A, 550B de nitrure est supporté par des plots reposant sur le substrat 100. De préférence, des puits quantiques 590 sont formés dans chaque vignette.

De préférence, on effectue une étape de protection des vignettes 550A ,550B, en particulier des flancs 552A, 552B des vignettes 550A, 550B. Cette étape comprend par exemple le dépôt d'une couche de protection, également désignée couche de passivation pour recouvrir les vignettes 550A, 550B. Ce dépôt est par exemple de type ALD (atomic layer déposition signifiant dépôt par couche atomique). Cela permet de former cette couche de protection sur toutes les surfaces des vignettes 550A, 550B, en particulier sur les flancs 552A, 552B et sur la face supérieure 551A, 551B des vignettes 550A, 550B. Il est également possible que cette couche de protection recouvre les parois latérales des plots.

Pour des raisons de clarté, cette couche de protection n'est pas illustrée sur la figure 12A. Cette couche de protection est de préférence une couche diélectrique. Elle est par exemple faite ou est à base de l'un des matériaux suivants : $SiO_2$, $Al_2O_3$, $Si_3N_4$, $HfO_2$. L'épaisseur de cette couche de protection est de préférence comprise entre 10nm et $1\mu m$.

Comme illustré en figure 12A, on dépose une couche diélectrique 600 qui recouvre les vignettes 550A, 550 B. Cette couche diélectrique 600 est déposée pleine plaque. Elle remplit la portion d'espace 630 situé entre les vignettes 550A, 550B. Cette couche recouvre les faces supérieures 551A, 551B des vignettes 550A, 550B. Cette couche diélectrique 600 est par exemple faite ou est à base de l'un des matériaux suivants : $SiO_2$, SiN.

Comme illustré en figure 12B, on amincit ensuite la couche diélectrique 600 de manière à rendre accessible les faces supérieures 551A, 551B des vignettes 550A, 550B. Pour cela, on peut effectuer un polissage mécanochimique (CMP) de planarisation. Cette étape de CMP est de préférence effectué avec arrêt sur les faces supérieures 551A, 551B des vignettes 550A, 550B dopées p.

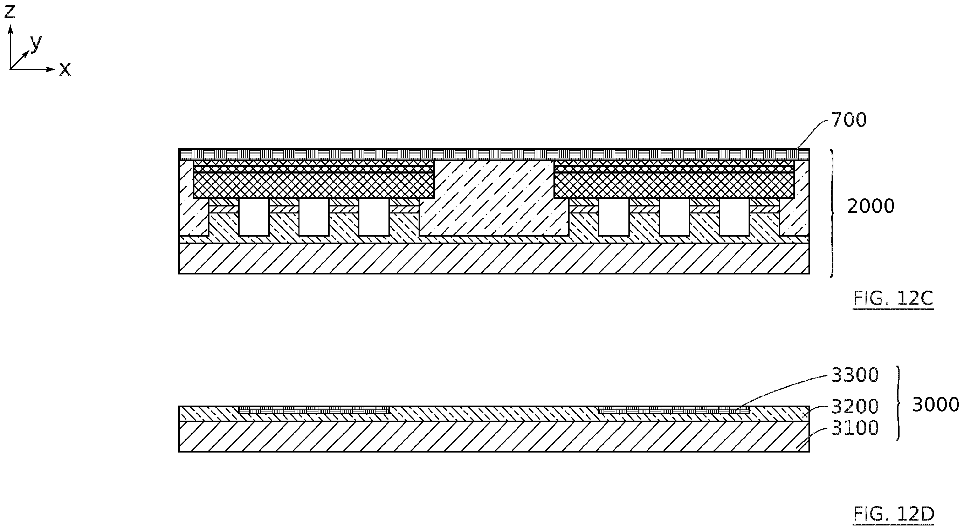

Comme illustré en figure 12C, une étape suivante consiste à réaliser un contact électrique 700 avec les faces supérieures 551A, 551B des vignettes 550A, 550B dopées p. Ce contact électrique est réalisé sous forme d'une couche électriquement conductrice. Elle est par exemple faite à base d'aluminium ou l'argent. L'empilement formé par le substrat 100, les plots, les vignettes 550A, 550B et le contact 700 est référencé 2000 en figure 12C.

Parallèlement ou à la suite des étapes décrites précédemment, on réalise un dispositif complémentaire 3000 tel qu'un circuit d'adressage ou un réseau d'interconnexions. Ce dispositif 3000 comprend par exemple un substrat 3100 surmonté d'une couche diélectrique 3200 et de zones conductrices 3300 destinées chacune à former une électrode, une anode dans cet exemple. Un tel dispositif 3000 et illustré en figure 12D. Le dispositif complémentaire est par exemple réalisé en technologie CMOS.

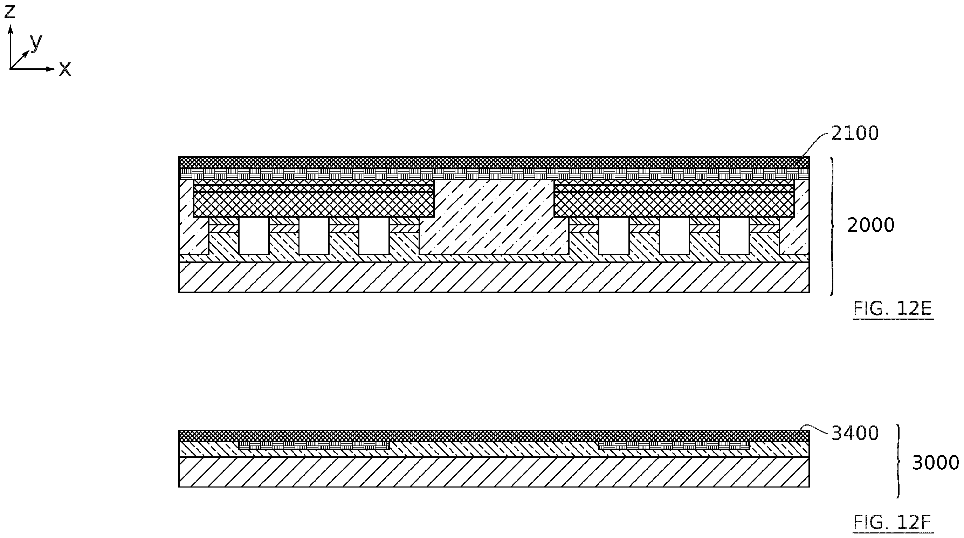

Comme illustré en figure 12E et 12F on effectue une étape de préparation du collage de l'empilement 2000 et du dispositif 3000.

Selon un premier mode de réalisation, cette étape de préparation du collage comprend le dépôt d'une couche de collage 2100 sur le contact électrique 700 de l'empilement 2000 et/ou le dépôt d'une couche de collage 3400 sur les zones conductrices 3300. Ces couches de collage 2100,3400 sont électriquement conductrices. Par exemple, ces couches de collage 2100, 3400 forment l'un des couples suivants de matériaux: TiN/AI, TiN/W, TiN/Ti.

Selon un mode de réalisation alternatif, le collage du contact électrique 700 de l'empilement 2000 sur les zones conductrices 3300 du dispositif 3000 est de type collage direct (direct bonding). Pour préparer ce collage direct, on peut effectuer un CMP sur au moins l'une de ces deux couches 700, 3300.

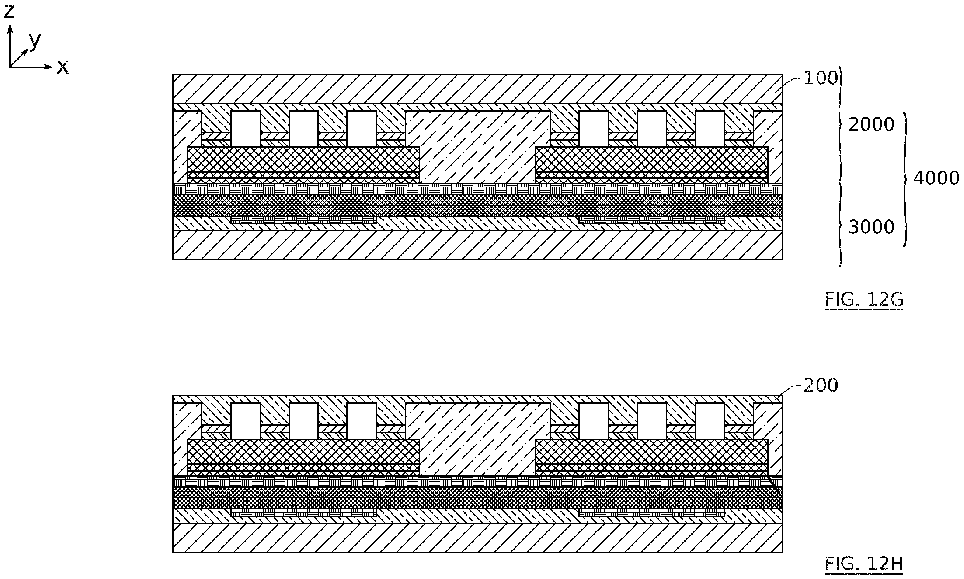

La figure 12G illustre le résultat du collage de l'empilement 2000 sur le dispositif 3000. Ainsi, les zones conductrices 3300 sont électriquement connectées au contact électrique 700. La structure obtenue est référencée 4000.

Dans le mode de réalisation avec dépôt de couches de collage 2100,3400, la conduction électrique entre le contact 700 et les zones conductrices 3300 s'effectue par l'intermédiaire de ces couches de collage 2100, 3400. De préférence, le collage comprend une thermocompression. Dans le mode de réalisation avec collage direct, les vignettes 550A, 550B portant le contact électrique sont disposées directement au contact des électrodes portées par dispositif 3000.

La figure 12H illustre le retrait du substrat 100 de support. Ce retrait est par exemple effectué par abrasion (grinding) d'une portion de l'épaisseur du substrat 100. Par exemple, on peut conserver une épaisseur d'environ 40 $\mu$m du substrat 100 après abrasion. Ensuite, on peut graver le matériau restant du substrat, soit par voie humide, soit par voie sèche. Pour rappel, ce substrat 100 est par exemple fait ou à base de silicium. À l'issue de cette étape, la couche de fluage 200 est mise à nu.

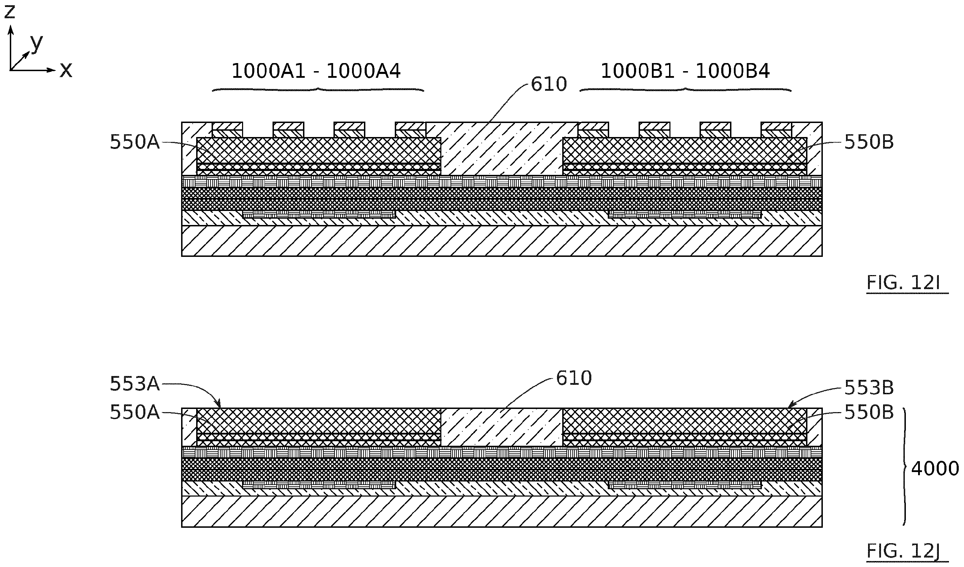

La figure 12I illustre le retrait de la couche de fluage 200. Pour rappel, cette couche de fluage est avantageusement la couche d'oxyde enterré (BOX) dans le cas où les vignettes 550A, 550B sont formées sur un substrat de type SOI. Cette étape de suppression de la couche de fluage 200 laisse des portions 610 de la couche diélectrique 600, ces portions 610 étant situées entre les vignettes 550A, 550B. Lors de cette étape de suppression de la couche de fluage 200, une portion de l'épaisseur de la couche 600 peut être consommée. C'est en particulier le cas lorsque la sélectivité de la gravure des couches 200 et 600 est faible ou nulle dans le cas où ces deux couches 200,600 sont faites d'un même matériau ($SiO_2$ typiquement).

À l'issue de cette étape, une portion des plots est mise à nu. En particulier, la portion cristalline et l'optionnelle portion tampon sont présentes à ce stade. En pratique, il a été remarqué que la portion tampon est encapsulée par la vignette de GaN.

Comme illustré en figure 12J, on supprime ensuite les portions résiduelles des plots 1000A1-1000B4. Cette étape s'effectue par exemple par polissage mécanochimique. À l'issue de cette étape, on s'assure que la face 553A, 553B des vignettes 550A, 550B est rendue accessible. On s'assure également que l'empilement 4000 présente une bonne planéité.

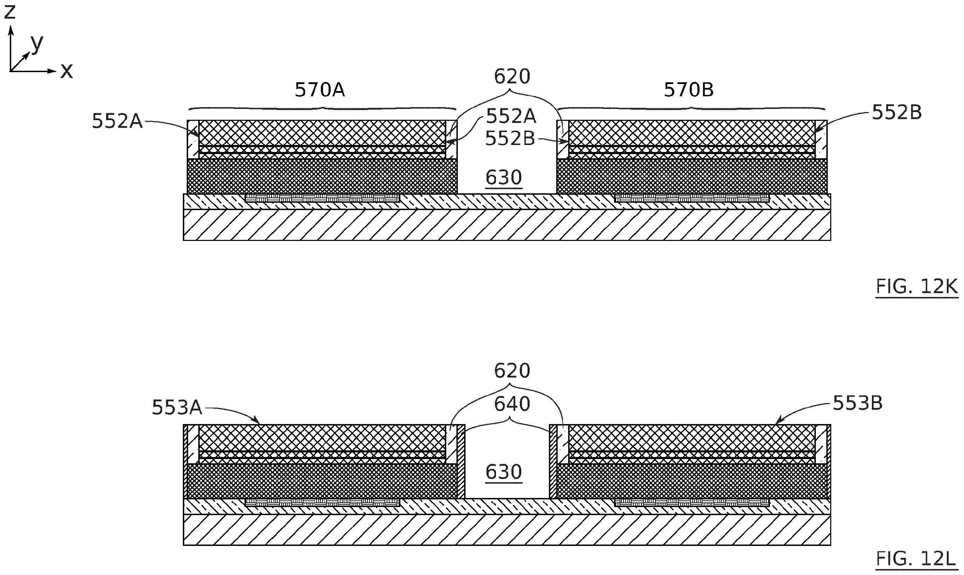

L'étape suivante, illustré en figure 12K, consiste à délimiter les micro-LED 570A, 570B. Pour cela, on effectue une gravure entre chaque vignette 550A, 550B. Cette gravure consiste à retirer la portion 610 de couche diélectrique 600 sur toute son épaisseur de sorte à mettre à nu la couche diélectrique 3200 du dispositif 3000. Ainsi cette gravure retire entre les micro-LED 570A, 570B les couches de collage 2100,3400 ainsi que la couche de contact 700. Cette gravure est arrêtée sur la couche électrique 3200 afin de conserver la fonction de cette dernière. Cette gravure est précédée d'une étape de lithographie effectuée de sorte à conserver une portion 620 de couche diélectrique 600 sur les flancs 552A, 552B des vignettes 550A, 550B. Ainsi, ces flancs 552A, 552B sont entièrement recouverts par un matériau diélectrique.

Comme illustré en figure 12L, on protège les flancs des ouvertures 630 les micro-LED 570A, 570B par un film diélectrique 640. De préférence, ce film diélectrique est réalisé par un dépôt pleine plaque d'une couche diélectrique suivie d'une gravure anisotrope dont la direction privilégiée est perpendiculaire aux faces 553A, 553B des vignettes 550A, 550B. Cette gravure anisotrope grave ainsi la couche diélectrique sur les surfaces horizontales et conserve cette couche diélectrique 640 sur les flancs des ouvertures 630.

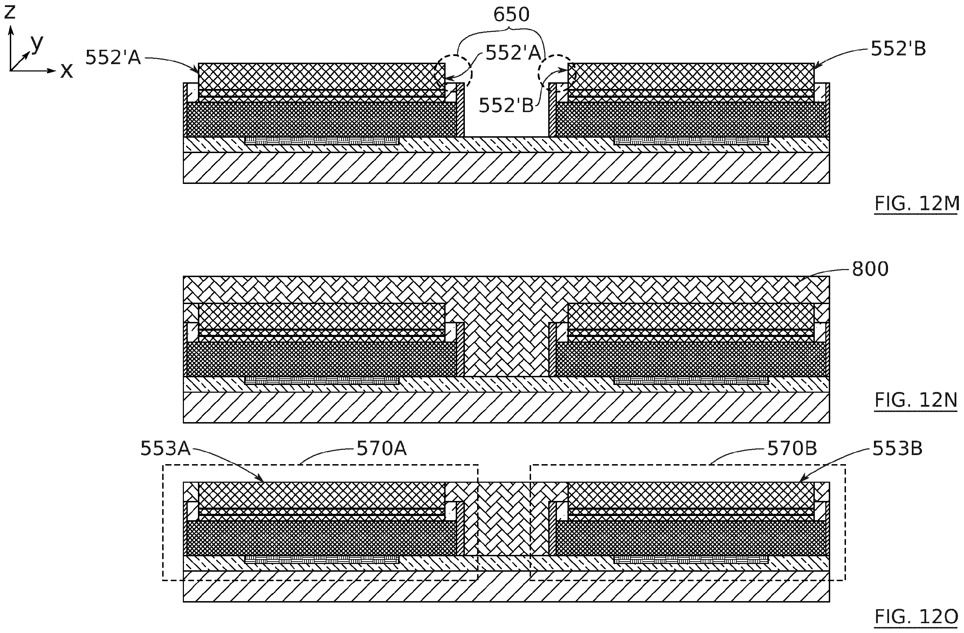

Comme illustré en figure 12M, on retire 650 une partie seulement du film 640 et des portions 620 de couche diélectrique 600 sur les flancs 552A, 552B des vignettes 550A, 550B. Ainsi, on découvre une partie 552'A, 552'B des flancs 552A, 552B des vignettes 550A, 550B, sans découvrir les puits quantiques 590. L'épaisseur gravée des portions 620, mesurée selon l'axe z, est donc contrôlée de sorte à ce que les puits quantiques 590 restent recouverts, au niveau des flancs 552A, 552B, par les portions 620 de couche diélectrique 600 et par le film 640.

Comme illustré en figure 12N, on effectue ensuite le dépôt pleine plaque d'une couche conductrice 800 qui remplit l'espace 630 situé entre les vignettes 550A, 550B et qui recouvrent ces dernières. De préférence, ce dépôt est effectué par électrolyse (ECD). La couche conductrice 800 est de préférence une couche métallique telle qu'une couche de cuivre. De manière optionnelle, on peut au préalable déposer une couche d'amorçage pour faciliter le collage de la couche métallique.

Comme illustré en figure 12O, on retire ensuite la couche conductrice 800 de sorte à rendre accessible les faces 553A, 553 B des vignettes 550A, 550B.

Il est ensuite possible de déposer une couche diélectrique sur ces faces 553A, 553B puis de réaliser les contacts pour connecter les micro-LED 570A, 570B ainsi réalisées.

**Exemple de réalisation de transistors de puissance à partir de vignettes**

Dans la description qui précède, il est indiqué que le principe du procédé proposé permet de réaliser efficacement des LEDs aux performances élevées. Ce procédé permet également de réaliser d'autres dispositifs de manière particulièrement avantageuse. Tel est le cas pour les dispositifs de puissance telle que les transistors de puissance. Les figures qui suivent décrivent certains exemples de tels dispositifs ainsi que des étapes permettant de les réaliser. De manière non limitative, les exemples décrits ci-dessous concerneront plus précisément des transistors de type HEMT.

La figure 13A illustre une structure que l'on obtient à l'issue de la mise en oeuvre du procédé décrit précédemment, par exemple en référence aux figures 3A à 3E ou 3A à 18C. On retrouve, un substrat 100, un tronçon de fluage 200, un tronçon cristallin 300, un tronçon optionnel formé par une couche tampon 400 et un tronçon optionnel formé par une couche d'amorçage 500. Sur les figures qui suivent, le tronçon optionnel formé par la couche d'amorçage 500 n'est pas illustré.

Cette structure illustrée en figure 13A, présente une vignette 550 de nitrure, de préférence faite à ou base de GaN. De préférence cette vignette n'est pas dopée de manière intentionnelle peut être qualifiée de UID, acronyme du vocable anglais unintentionally doped. Cette structure présente également une couche 740, surmontant la vignette 550. Cette couche 740 est à base de nitrure. Elle est de préférence formée par épitaxie à partir de la vignette 550. Dans le cas d'un transistor HEMT, si la vignette 550 est faite de GaN, la couche 740 peut être faite d'AlGaN.

Dans le cas d'un transistor HEMT, la vignette 550 est le siège du canal et la couche 740 est la couche barrière.

Typiquement, la vignette de nitrure 550 présente une épaisseur, prise perpendiculairement à la face supérieure du substrat 100, de l'ordre de $10\mu m$. Typiquement, la couche barrière 740 présente une épaisseur de l'ordre de 25 nm.

La figure 13B illustre plusieurs structures de ce type formées à la surface d'un même substrat 100 est reposant sur des plots. Naturellement, ces structures peuvent être formées en mettant en oeuvre l'un des procédés décrits ci-dessus.

La figure 13C illustre une structure alternative à la structure illustrée en figure 13A. Dans la structure illustrée en figure 13C, qui peut également servir à former un transistor HEMT, la vignette 550 repose sur les plots et est surmontée des couches successives suivantes, empilées depuis la face supérieure 551 de la vignette 550:

- une couche barrière arrière 710 (habituellement désignée par le vocable anglais back barrier). Cette couche est par exemple formée AlGaN/pGaN. Elle peut présenter une épaisseur comprise entre 50-100nm. Cette couche est optionnelle. Cette couche permet d'améliorer le confinement du gaz bidirectionnel d'électrons.

- une couche 720 destinée à former le canal pour le transistor. Cette couche est de préférence faite ou à base de GaN. Elle présente par exemple une épaisseur comprise entre 100 et 300 nanomètres.

- une couche 730 d'espaceur. Cette couche est de préférence faite ou à base d'AlN. Elle présente par exemple une épaisseur de l'ordre de 1 nanomètre. Cette couche est optionnelle. Cette couche permet d'améliorer le confinement et donc d'augmenter la mobilité des porteurs de charges.

- la couche 740 destinée à former la couche barrière pour le transistor. Cette couche est de préférence faite ou à base d'AlGaN. Elle présente par exemple une épaisseur comprise entre 10 et 25 nanomètres.

- une couche 750 de passivation. Cette couche est de préférence faite de nitrure, par exemple de SiN. Elle présente par exemple une épaisseur comprise entre 2 et 50 nanomètres. Cette couche est optionnelle. Elle permet d'éviter le piégeage de charges en surface.

La vignette 550 de nitrure peut présenter une épaisseur de l'ordre de 10 micromètres.

De préférence, les couches 710, 720, 730, 740 sont formés par épitaxie, de préférence à partir de la vignette de nitrure 550. La couche 750 peut être déposée par CVD (dépôt chimique en phase vapeur) ou MOCVD (dépôt chimique en phase vapeur aux organométalliques).

Les structures des figures 13A et 13C peuvent subir des étapes additionnelles, notamment pour retirer les plots.

Le procédé proposé présente comme avantage considérable de permettre la réalisation de vignettes 550 d'épaisseur importante typiquement supérieure à 5 micromètres, de préférence de l'ordre de 10 micromètres, avec très peu voire sans fractures, dislocations et avec très peu voire sans déformations de la plaque (wafer). Cette forte épaisseur de la couche de nitrure permet de réduire les fuites verticales et d'augmenter la tension de claquage. Le procédé proposé permet ainsi d'améliorer considérablement les performances des transistors de puissance telle que les transistors HEMTs.

La figure 14A, illustre un substrat 100 sur lequel repose plusieurs dispositifs, destinés chacun à former un transistor HEMT 554. Chaque transistor 554 présente une source 760, un drain 770 et une grille 180. Ce mode de réalisation présente pour avantage d'être particulièrement simple à réaliser.

La figure 14B illustre un mode de réalisation alternatif, dans lequel une couche diélectrique sépare les différents transistors 554. Cette couche diélectrique 910 est par exemple déposée par centrifugation. Et peut-être de type SOG (acronyme de l'anglais désigne spin-on-glass, signifiant verre déposé par centrifugation). Cette couche diélectrique 910 permet de stabiliser mécaniquement les vignettes 550.

Cette couche diélectrique 910 permet également d'isoler électriquement les différents transistors 554, notamment lorsqu'ils sont fonctionnels. Comme illustré en figure 14B, une portion 911 de la couche diélectrique 910 sépare en effet de transistors 554 voisins. Cela permet par exemple d'éviter des courts-circuits entre sources 760 qui se font face ou entre drains 770 qui se font face, comme cela est illustré en figure 14A. En effet, il est préférable que les sources et drains de deux transistors 554 voisins soient disposés de manière symétrique. Comme on le verra par la suite, en référence aux figures 16A à 17, cela permet de faciliter la connexion ultérieure des sources 760 et drains 770. En particulier, cela permet d'avoir à une même position les tensions basses élevées.

Un exemple de réalisation d'un transistor 554 va maintenant être décrit en référence aux figures 15A à 15D. Ce transistor peut être identique à celui illustré en figure 14B.

La figure 15A illustre le substrat 100 surmonté des plots 200, 300, 400 qui supportent la vignette 550 ainsi qu'au moins la couche barrière 740. Naturellement, au moins l'une est de préférences plusieurs des couches 710, 720, 730, 750 décrites précédemment peut être présente. De préférence, une couche diélectrique 910 est déposée comme décrit en référence à la figure 14B. Cette couche diélectrique 910 recouvre la face libre de chacune des structures 554. Un substrat poignée 920 est ensuite fixé sur la face libre de la couche diélectrique 910.

Comme illustré en figure 15B, le substrat 100 ainsi que les plots sont ensuite retirés. Cela peut par exemple être effectué par gravure, meulage ou polissage mécanochimique (CMP). Ce retrait est effectué jusqu'à rendre accessible une face des vignettes 550 de nitrure. De préférence, avant ce retrait par amincissement, on aura retourné l'empilement.

Comme illustré en figure 15C, un substrat additionnel 930 est ensuite fixé sur la face rendue accessible des vignettes 550 de nitrure. Le substrat poignée 920 est ensuite retiré. Le substrat additionnel 930 et conservé. Il peut s'agir d'un substrat définitif.

La couche diélectrique 910 de protection est ensuite retirée de sorte à rendre accessible la couche barrière 740.

On peut ensuite former les sources 760, drains 770, grilles 780 pour finaliser les transistors 554.

De préférence, les portions de couche diélectrique 910 située entre deux transistors 554 sont conservées.

La figure 16A est une vue du dessus de la structure représentée en figure 15D.

Cette figure 16A fait ressortir plus clairement encore la symétrie de la disposition des sources 760, drains 770 et grilles 780 appartenant à deux transistors 554 adjacents.

Ainsi, l'axe X1 est un axe de symétrie pour la disposition des sources 760, drains 770 et grilles 780 appartenant à deux transistors 554 adjacents, tandis que l'axe X2 est un axe de symétrie pour la disposition des sources 760, drains 770 et grilles 780 appartenant à deux autres transistors 554 adjacents.

Comme illustré en figure 16B, cette symétrie entre deux autres transistors 554 voisins permet de faciliter :

- la connexion des sources 760 avec un point de contact électrique commun 760',

- la connexion des drains 770 avec un point de contact électrique commun 770',

- la connexion des grilles 780 avec un point de contact électrique commun 780'.

La figure 17 est une vue du dessus d'une structure alternative à celle illustrée en figures 15D et 16A. Dans cette structure alternative, chaque transistor 554 présente un drain central 770, ainsi que de sources 760, et deux grilles 780. Les sources 760 sont disposées de part et d'autre du drain 770. Les grilles 780 sont également disposées de part et d'autre du drain 770.

Au vu de la description qui précède, il apparaît clairement que la présente invention propose une solution particulièrement efficace pour obtenir une pluralité de vignettes épitaxiées, destinée chacune à former une micro-LED et dont la densité de défauts est considérablement réduite.

L'invention n'est pas limitée aux modes de réalisation décrits ci-dessus et s'étend à tous les modes de réalisation couverts par les revendications.

**Revendications**

1. Procédé d'obtention d'une pluralité de vignettes (550A, 550B), chaque vignette (550A, 550B) étant faite au moins en partie d'un nitrure (N) obtenu de préférence à partir d'au moins l'un parmi le gallium (Ga), l'indium (In) et l'aluminium (Al), le procédé comprenant les étapes successives suivantes:

- fournir un empilement comprenant un substrat (100) et au moins les couches suivantes successivement disposées depuis le substrat (100):

 ◦ une première couche, dite couche de fluage (200), faite en un matériau présentant une température de transition vitreuse, la couche de fluage (200) présentant une température de transition vitreuse $T_{transition\ vitreuse}$,
 ◦ une deuxième couche, cristalline, dite couche cristalline (300), différente de la couche de fluage (200),

- former des plots (1000A1-1000B4) par gravure au moins de la couche cristalline (300) et d'au moins une portion de la couche de fluage (200) de manière à ce que :

 ◦ chaque plot (1000A1-1000B4) comporte au moins :

  ▪ un premier tronçon, dit tronçon de fluage (220A1- 220B4), formé par une portion au moins de la couche de fluage (200),
  ▪ un deuxième tronçon, cristallin, dit tronçon cristallin (300A1, 300B4), formé par la couche cristalline (300) et surmontant le tronçon de fluage (220A1-220B4),

 ◦ les plots (1000A1-1000B4) soient répartis sur le substrat (100) de manière à former une pluralité d'ensembles (1000A, 1000B) de plots (1000A1-1000B4),

- faire croître par épitaxie une cristallite (510A1-510B4) sur certains au moins desdits plots (1000A1-1000B4) et poursuivre la croissance épitaxiale des cristallites (510A1-510B4) jusqu'à coalescence des cristallites (510A1-510B4) portées par les plots (1000A1-1000B4) adjacents d'un même ensemble (1000A, 1000B), de manière à former sur chaque ensemble (1000A, 1000B) une vignette (550A, 550B) de nitrure, la croissance épitaxiale étant effectuée à une température $T_{épitaxie}$, telle que :

$$T_{épitaxie} \geq k1 \times T_{transition\ vitreuse},\ \text{avec } k1 \geq 0,8$$

avec k1 ≥ 0,8
- interrompre la croissance épitaxiale des cristallites (510A1-510B4) avant que des cristallites (510A1-510B4) appartenant à deux ensembles (1000A, 1000B) distincts n'entrent en coalescence, de sorte à ce que les vignettes (550A, 550B) de chaque ensemble (1000A, 1000B) soient distantes les unes des autres.

2. Procédé selon la revendication précédente dans lequel la distance D séparant deux plots adjacents (1000A1, 1000A2) d'un même ensemble (1000A) est inférieure à la distance W1 séparant deux plots adjacents (1000A4, 1000B1) appartenant à deux ensembles (1000A, 1000B) différents, avec W1 > D et de préférence W1 ≥ k4 × D, avec k4= 1.5 et de préférence k4=2.

3. Procédé selon l'une quelconque des revendications précédentes dans lequel:

 - W1 est la distance séparant deux plots (1000A4-1000B1) adjacents appartenant à deux ensembles (1000A, 1000B) distincts,
 - W2 est la distance séparant deux vignettes (550A, 550B) adjacentes,

et dans lequel :

$$W1 \geq k5 \times W2$$

avec k5=1.5, de préférence k5=2

4. Procédé selon l'une quelconque des revendications précédentes dans lequel chaque plot (1000A1-1000B4) présente une section dont la dimension maximale $d_{plot}$ est comprise entre 10 et 500 nm ($10^{-9}$ mètres), la dimension maximale $d_{plot}$ étant mesurée dans un plan parallèle à un plan (xy) dans lequel s'étend principalement une face supérieure (110) du substrat (100), de préférence 20 nm ≤ $d_{plot}$ ≤ 200 nm et de préférence 50 nm ≤ $d_{plot}$ ≤ 100 nm et de préférence dans lequel chaque vignette (550A, 550B) présente une section dont la dimension maximale $d_{vignette}$

est comprise entre 0,5 à 10 $\mu$m ($10^{-6}$ mètres), la dimension maximale $d_{vignette}$ étant mesurée dans un plan parallèle à un plan (xy) dans lequel s'étend principalement une face supérieure (110) du substrat (100), de préférence 0.8 $\mu$m $\leq d_{vinette} \leq$ 3 $\mu$m et de préférence 1 $\mu$m $\leq d_{vinette} \leq$ 2 $\mu$m.

5. Procédé selon l'une quelconque des revendications précédentes dans lequel les plots (1000A1-1000A4) d'un même ensemble (1000A) sont répartis sur le substrat (100) de manière périodique selon une période $p_{plot}$, avec 200 nm $\leq p_{plot} \leq$ 2000 nm, et de préférence 200 nm $\leq p_{plot} \leq$ 500 nm.

6. Procédé selon l'une quelconque des revendications précédentes dans lequel la couche de fluage (200) est faite d'un matériau pris parmi :

   - un oxyde de silicium SixOy, x et y étant des entiers, et de préférence la couche de fluage est en SiO2,
   - un verre,
   - un verre en borosilicate,
   - un verre en borophosphosilicate (BPSG).

7. Procédé selon l'une quelconque des revendications précédentes, dans lequel $T_{épitaxie} \leq$ k2 $\times$ $T_{fusion\ min}$, $T_{fusion\ min}$ étant la température de fusion la plus faible parmi les températures de fusion des tronçons formant les plots (1000A1-1000B4), avec k2 $\leq$ 0,9 et de préférence k2 $\leq$ 0,8.

8. Procédé selon l'une quelconque des revendications précédentes, dans lequel les plots (1000A1-1000B4) présentent une hauteur $H_{plot}$, et dans lequel deux plots (1000A1-1000B4) adjacents sont distants d'une distance D, telle que : $H_{plot}$/ D < 2 et de préférence $H_{plot}$ / D $\leq$ 1.

9. Procédé selon l'une quelconque des revendications précédentes, dans lequel l'étape de formation des plots (1000A1-1000B4) comprend la gravure de la couche cristalline (300) et la gravure d'une portion (220) seulement de la couche de fluage (200) de manière à conserver une portion (210) de la couche de fluage (200) entre les plots (1000A1-1000B4).

10. Procédé selon l'une quelconque des revendications précédentes, dans lequel chaque plot (1000A1-1000B4) présente une face supérieure (1001A1) et dans lequel la croissance par épitaxie des cristallites (510A1-510B4) s'effectue en partie au moins et de préférence uniquement à partir de ladite face supérieure (1001A1).

11. Procédé selon l'une quelconque des revendications précédentes, comprenant, après ladite formation des plots (1000A1-1000B4), et avant ladite croissance par épitaxie des cristallites (510A1-510B4), une étape d'amincissement des tronçons de fluage (220A1- 220B4) par gravure sélective des tronçons de fluage vis à vis d'au moins les tronçons cristallins (300A1-300B4).

12. Procédé selon l'une quelconque des revendications précédentes, comprenant une étape de formation d'une couche barrière (740), de préférence d'AlGaN, sur les vignettes (550A, 550B) de nitrure, puis une étape de formation d'au moins une source (760), d'un drain (770) et d'une grille (780) sur la couche barrière (740).

13. Procédé de formation d'une pluralité de diodes électroluminescentes (LED) (570A, 570B) comprenant au moins les étapes successives suivantes :

   - formation d'une pluralité de vignettes (550A, 550B) destinées chacune à former une LED, la pluralité de vignettes (550A, 550B) étant obtenue en mettant en oeuvre le procédé selon l'une quelconque des revendications 1 à 11,
   - réalisation dans les vignettes (550A, 550B) de la pluralité de vignettes (550A, 550B) d'au moins l'un parmi :

     ◦ au moins une jonction p/n,
     ◦ au moins un puit quantique.

14. Dispositif microélectronique comprenant un substrat (100) surmonté d'une pluralité de vignettes (550A, 550B) faites chacune d'un nitrure (N) obtenu de préférence à partir d'au moins l'un parmi le gallium (Ga), l'indium (In) et l'aluminium (Al), le dispositif comprenant également une pluralité de plots (1000A1-1000B4) s'étendant entre le substrat (100) et la pluralité de vignettes (550A, 550B), chaque vignette (550A, 550B) étant entièrement supportée par un ensemble (1000A, 1000B) de plots (1000A1- 1000B4) pris parmi ladite pluralité de plots (1000A1- 1000B4): chaque plot (1000A1- 1000B4) comprend au moins :

- un premier tronçon, dit tronçon de fluage (220A1, 220B4), présentant une température de transition vitreuse $T_{\text{transition vitreuse}}$,
- un deuxième tronçon, dit tronçon cristallin (300A1, 300B4) formé d'un matériau cristallin, le tronçon de fluage (220A1, 220B4) et le tronçon cristallin (300A1, 300B4) étant successivement disposés depuis le substrat (100),

le matériau du tronçon de fluage (200A1- 200B4) et ledit nitrure étant choisis de manière à ce que:

$$T_{\text{épitaxie}} \geq k1 \text{ x } T_{\text{transition vitreuse}}, \text{ avec k1=0.8,}$$

$T_{\text{épitaxie}}$ étant la température minimale permettant la formation par épitaxie dudit nitrure dans lequel sont faites les vignettes (550A, 550B).

15. Système optoélectronique comprenant un dispositif microélectronique selon la revendication précédente dans lequel au moins certaines et de préférence chaque vignette (550A, 550B) forme en partie au moins :

- une diode électroluminescente (LED), ou
- un transistor (554), de préférence un transistor à haute mobilité d'électrons (HEMT).

**Patentansprüche**

1. Verfahren zum Erlangen einer Vielzahl von Kacheln (550A, 550B), wobei jede Kachel (550A, 550B) mindestens teilweise aus einem Nitrid (N) besteht, das vorzugsweise ausgehend von mindestens einem aus Gallium (Ga), Indium (In) und Aluminium (Al) erlangt wird, wobei das Verfahren die folgenden aufeinanderfolgenden Schritte umfasst:

- Bereitstellen eines Stapels, der ein Substrat (100) umfasst und mindestens die folgenden Schichten, die nacheinander vom Substrat (100) aus angeordnet sind:

 ◦ eine erste Schicht, Kriechschicht (200) genannt, die aus einem Material besteht, das eine Glasübergangstemperatur aufweist, wobei die Kriechschicht (200) eine Glasübergangstemperatur $T_{\text{Glasübergang}}$ aufweist,
 ◦ eine zweite kristalline Schicht, Kristallschicht (300) genannt, die sich von der Kriechschicht (200) unterscheidet,

- Bilden von Pads (1000A1-1000B4) durch Ätzen mindestens der Kristallschicht (300) und mindestens eines Bereichs der Kriechschicht (200), so dass:

 ◦ jedes Pad (1000A1-1000B4) mindestens beinhaltet:

  ▪ einen ersten Abschnitt, Kriechabschnitt (220A1-220B4) genannt, der durch mindestens einen Bereich der Kriechschicht (200) gebildet wird,
  ▪ einen zweiten kristallinen Abschnitt, Kristallabschnitt (300A1, 300B4) genannt, der durch die Kristallschicht (300) gebildet wird, und den Kriechabschnitt (220A1-220B4) überragt,

 ◦ wobei die Pads (1000A1-1000B4) auf dem Substrat (100) so verteilt sind, dass sie eine Vielzahl von Sätzen (1000A, 1000B) von Pads (1000A1-1000B4) bilden,

- Aufwachsen lassen eines Kristalliten (510A1-510B4) durch Epitaxie auf mindestens einigen der Pads (1000A1-1000B4), und Fortsetzen des epitaktischen Wachstums der Kristallite (510A1-510B4), bis zur Koaleszenz der Kristallite (510A1-510B4), die von benachbarten Pads (1000A1-1000B4) desselben Satzes (1000A, 1000B) so getragen werden, dass sie auf jedem Satz (1000A, 1000B) eine Kachel (550A, 550B) aus Nitrid bilden, wobei das epitaktische Wachstum bei einer Temperatur $T_{\text{Epitaxie}}$ durchgeführt wird, so dass:

$$T_{\text{Epitaxie}} \geq k1 \text{ x } T_{\text{Glasübergang}}, \text{ wobei } k1 \geq 0,8,$$

- Unterbrechen des epitaktischen Wachstums von Kristalliten (510A1-510B4), bevor Kristallite (510A1-510B4), die zu zwei unterschiedlichen Sätzen (1000A, 1000B) gehören, in Koaleszenz eintreten, so dass die Kacheln (550A, 550B) jedes Satzes (1000A, 1000B) voneinander entfernt sind.

2. Verfahren nach dem vorhergehenden Anspruch, wobei der Abstand D, zwischen zwei benachbarten Pads (1000A1, 1000A2) desselben Satzes (1000A), kleiner ist als der Abstand W1, zwischen zwei benachbarten Pads (1000A4, 1000B1), die zu zwei verschiedenen Sätzen (1000A, 1000B) gehören, wobei W1 > D und vorzugsweise W1 $\geq$ K4 ◦ D, wobei k4 = 1,5 und vorzugsweise k4 = 2.

3. Verfahren nach einem der vorhergehenden Ansprüche, wobei:

- W1 der Abstand zwischen zwei benachbarten Pads (1000A4-1000B1) ist, die zu zwei unterschiedlichen Sätzen (1000A, 1000B) gehören,
- W2 der Abstand zwischen zwei benachbarten Kacheln (550A, 550B) ist,

und wobei:

$$W1 \geq k5 \times W2,$$

wobei k5 = 1,5, vorzugsweise k5 = 2.

4. Verfahren nach einem der vorhergehenden Ansprüche, wobei jedes Pad (1000A1-1000B4) einen Querschnitt aufweist, dessen maximale Abmessung $d_{Pad}$ zwischen 10 und 500 nm ($10^{-9}$ Meter) liegt, wobei die maximale Abmessung $d_{Pad}$ in einer Ebene parallel zu einer Ebene (xy) gemessen wird, in der sich hauptsächlich eine Oberseite (110) des Substrats (100) erstreckt, vorzugsweise 20 nm $\leq d_{Pad} \leq$ 200 nm und vorzugsweise 50 nm $\leq d_{Pad} \leq$ 100 nm, und wobei vorzugsweise jede Kachel (550A, 550B) einen Querschnitt aufweist, dessen maximale Abmessung $d_{Kachel}$ zwischen 0,5 und 10 pm ($10^{-6}$ Meter) liegt, wobei die maximale Abmessung $d_{Kachel}$ in einer Ebene parallel zu einer Ebene (xy) gemessen wird, in der sich hauptsächlich eine Oberseite (110) des Substrats (100) erstreckt, vorzugsweise 0,8 $\mu$m $\leq d_{Kachel} \leq$ 3 pm und vorzugsweise 1 $\mu$m $\leq d_{Kachel} \leq$ 2 $\mu$m.

5. Verfahren nach einem der vorhergehenden Ansprüche, wobei die Pads (1000A1-1000A4) desselben Satzes (1000A) periodisch auf dem Substrat (100) verteilt sind, gemäß einer Periode $p_{Pad}$, wobei 200 nm $\leq p_{Pad} \leq$ 2000 nm und vorzugsweise 200 nm $\leq p_{Pad} \leq$ 500 nm.

6. Verfahren nach einem der vorhergehenden Ansprüche, wobei die Kriechschicht (200) aus einem Material besteht, das ausgewählt wird aus:

- einem Siliciumoxid SixOy, wobei x und y Ganzzahlen sind, und die Kriechschicht vorzugsweise SiO2 ist,
- einem Glas,
- einem Borosilikatglas,
- einem Glas aus Borophosphosilikat (BPSG).

7. Verfahren nach einem der vorhergehenden Ansprüche, wobei $T_{Epitaxie} \leq k2 \times T_{Schmelze\ min}$, wobei $T_{Schmelze\ min}$ die niedrigste Schmelztemperatur unter den Schmelztemperaturen der Abschnitte ist, die die Pads (1000A1-1000B4) bilden, wobei k2 $\leq$ 0,9 und vorzugsweise k2 $\leq$ 0,8.

8. Verfahren nach einem der vorhergehenden Ansprüche, wobei die Pads (1000A1-1000B4) eine Höhe $H_{Pad}$ aufweisen, und wobei zwei benachbarte Pads (1000A1-1000B4) um einen Abstand D voneinander entfernt sind, wobei: $H_{pad}$ / D < 2 und vorzugsweise $H_{Pad}$ / D $\leq$ 1.

9. Verfahren nach einem der vorhergehenden Ansprüche, wobei der Schritt der Bildung der Pads (1000A1-1000B4) das Ätzen der Kristallschicht (300) und das Ätzen nur eines Bereichs (220) der Kriechschicht (200) umfasst, so dass ein Bereich (210) der Kriechschicht (200) zwischen den Pads (1000A1-1000B4) erhalten bleibt.

10. Verfahren nach einem der vorhergehenden Ansprüche, wobei jedes Pad (1000A1-1000B4) eine Oberseite (1001A1) aufweist, und wobei das Wachstum durch Epitaxie der Kristallite (510A1-510B4) mindestens teilweise und vorzugsweise nur von der Oberseite (1001A1) ausgehend erfolgt.

**11.** Verfahren nach einem der vorhergehenden Ansprüche, nach der Bildung der Pads (1000A1-1000B4) und vor dem Wachstum durch Epitaxie der Kristallite (510A1-510B4), einen Schritt des Ausdünnens der Kriechabschnitte (220A1-200B4) umfassend durch selektives Ätzen der Kriechabschnitte gegenüber mindestens den Kristallabschnitten (300A1-300B4).

**12.** Verfahren nach einem der vorhergehenden Ansprüche, einen Schritt der Bildung einer Sperrschicht (740) umfassend, vorzugsweise aus AlGaN, auf den Kacheln (550A, 550B) aus Nitrid, und dann einen Schritt der Bildung mindestens einer Source (760), eines Drains (770) und eines Gates (780) auf der Sperrschicht (740).

**13.** Verfahren zur Bildung einer Vielzahl von Leuchtdioden (LED) (570A, 570B), mindestens die folgenden aufeinanderfolgenden Schritte umfassend:

- Bildung einer Vielzahl von Kacheln (550A, 550B), die bestimmt sind, um jeweils eine LED zu bilden, wobei die Vielzahl von Kacheln (550A, 550B) erlangt werden, indem ein Verfahren nach einem der Ansprüche 1 bis 11 durchgeführt wird,
- Realisierung in den Kacheln (550A, 550B) der Vielzahl von Kacheln (550A, 550B) von mindestens einem aus:

  ◦ mindestens einem p/n-Übergang,
  ◦ mindestens einem Quantentopf.

**14.** Mikroelektronische Vorrichtung, die ein Substrat (100) umfasst, das von einer Vielzahl von Kacheln (550A, 550B) überragt wird, die jeweils aus einem Nitrid (N) bestehen, das vorzugsweise ausgehend von mindestens einem von Gallium (Ga), Indium (In) und Aluminium (Al) erlangt wird, wobei die Vorrichtung auch eine Vielzahl von Pads (1000A1-1000B4) umfasst, die sich zwischen dem Substrat (100) und der Vielzahl von Kacheln (550A, 550B) erstrecken, wobei jede Kachel (550A, 550B) vollständig von einem Satz (1000A, 1000B) von Pads (1000A1-1000B4) unterstützt wird, die aus der Vielzahl von Pads (1000A1-1000B4) ausgewählt werden:

wobei jedes Pad (1000A1-1000B4) mindestens umfasst:

- einen ersten Abschnitt, Kriechabschnitt (220A1, 220B4) genannt, der eine Glasübergangstemperatur $T_{Glasübergang}$ aufweist,
- einen zweiten Abschnitt, Kristallabschnitt (300A1, 300B4) genannt, der aus einem kristallinen Material gebildet ist, wobei der Kriechabschnitt (220A1, 220B4) und der Kristallabschnitt (300A1, 300B4) nacheinander vom Substrat (100) aus angeordnet sind,

wobei das Material des Kriechabschnitts (200A1-200B4) und das Nitrid so ausgewählt sind, dass:

$$T_{Epitaxie} \geqslant k1 \times T_{Glasübergang}, \text{ wobei } k1 = 0,8,$$

wobei $T_{Epitaxie}$ die Mindesttemperatur ist, die die Bildung durch Epitaxie des Nitrids, aus dem die Kacheln (550A, 550B) bestehen, ermöglicht.

**15.** Optoelektronisches System, eine mikroelektronische Vorrichtung nach dem vorhergehenden Anspruch umfassend, wobei mindestens einige und vorzugsweise jede Kachel (550A, 550B) mindestens teilweise bildet:

- eine Leuchtdiode (LED) oder
- einen Transistor (554), vorzugsweise einen Transistor mit hoher Elektronenbeweglichkeit (HEMT).

**Claims**

**1.** A method for obtaining a plurality of mesas (550A, 550B), each mesa (550A, 550B) being at least partly made of a nitride (N) preferably obtained from at least one of gallium (Ga), indium (In) and aluminium (Al), the method comprising the following successive steps:

- providing a stack comprising a substrate (100) and at least the following layers successively arranged from the substrate (100):

o a first layer, referred to as the creep layer (200), made of a material having a glass transition temperature, the creep layer (200) having a glass transition temperature $T_{\text{glass transition}}$,
o a second, crystalline layer, referred to as the crystalline layer (300), different from the creep layer (200),

- forming pads (1000A1-1000B4) by etching at least the crystalline layer (300) and at least one portion of the creep layer (200) so that:

o each pad (1000A1-1000B4) includes at least:

- a first section, referred to as the creep section (220A1-220B4), formed by at least one portion of the creep layer (200),
- a second, crystalline section, referred to as the crystalline section (300A1, 300B4), formed by the crystalline layer (300) and being above the creep section (220A1-220B4),

o the pads (1000A1-1000B4) are distributed over the substrate (100) so as to form a plurality of sets (1000A, 1000B) of pads (1000A1-1000B4),

- epitaxially growing a crystallite (510A1-510B4) on at least some of said pads (1000A1-1000B4) and continuing epitaxially growing the crystallites (510A1-510B4) until the crystallites (510A1-510B4) carried by the adjacent pads (1000A1-1000B4) of a same set (1000A, 1000B) coalesce, so as to form a nitride mesa (550A, 550B) on each set (1000A, 1000B), epitaxially growing being carried out at a temperature $T_{\text{epitaxy}}$, such that:

$$T_{\text{epitaxy}} \geq k1 \times T_{\text{glass transition}}, \text{ with } k1 \geq 0.8$$

- stopping epitaxially growing the crystallites (510A1-510B4) before crystallites (510A1-510B4) belonging to two distinct sets (1000A, 1000B) begin to coalesce, so that the mesas (550A, 550B) of each set (1000A, 1000B) are spaced apart from each other.

2. The method according to the preceding claim, wherein the distance D separating two adjacent pads (1000A1, 1000A2) of a same set (1000A) is less than the distance W1 separating two adjacent pads (1000A4, 1000B1) belonging to two different sets (1000A, 1000B), with W1 > D and preferably $W1 \geq k4 \times D$, with k4=1.5 and preferably k4=2.

3. The method according to any of the preceding claims, wherein:

- W1 is the distance separating two adjacent pads (1000A4-1000B1) belonging to two distinct sets (1000A, 1000B),
- W2 is the distance separating two adjacent mesas (550A, 550B),
and wherein: $W1 \geq k5 \times W2$
with k5=1.5, preferably k5=2.

4. The method according to any of the preceding claims, wherein each pad (1000A1-1000B4) has a cross-section whose maximum dimension $d_{\text{pad}}$ is between 10 and 500 nm ($10^{-9}$ metre), the maximum dimension $d_{\text{pad}}$ being measured in a plane parallel to a plane (xy) in which an upper face (110) of the substrate (100) mainly extends, preferably $20 \text{ nm} \leq d_{\text{pad}} \leq 200 \text{ nm}$ and preferably $50 \text{ nm} \leq d_{\text{pad}} \leq 100 \text{ nm}$ and preferably wherein each mesa (550A, 550B) has a cross-section with a maximum dimension $d_{\text{mesa}}$ of between 0.5 and 10 pm ($10^{-6}$ metres), the maximum dimension $d_{\text{mesa}}$ being measured in a plane parallel to a plane (xy) in which an upper face (110) of the substrate (100) mainly extends, preferably $0.8 \text{ }\mu\text{m} \leq d_{\text{mesa}} \leq 3 \text{ }\mu\text{m}$ and preferably $1 \text{ pm} \leq d_{\text{mesa}} \leq 2 \text{ pm}$.

5. The method according to any of the preceding claims, wherein the dots (1000A1-1000A4) of a same set (1000A) are distributed over the substrate (100) periodically with a period $p_{\text{pad}}$, with
$200 \text{ nm} \leq p_{\text{Pad}} \leq 2000 \text{ nm}$, and preferably $200 \text{ nm} \leq p_{\text{Pad}} \leq 500 \text{ nm}$.

6. The method according to any of the preceding claims, wherein the creep layer (200) is made of a material selected from:

- a silicon oxide SixOy, x and y being integers, and preferably the creep layer is made of $SiO_2$,

- a glass,
- borosilicate glass,
- borophosphosilicate (BPSG) glass.

7. The method according to any of the preceding claims, wherein $T_{epitaxy} \leq k2 \times T_{min\ melting}$, $T_{min\ melting}$ being the lowest melting temperature among the melting temperatures of the sections forming the pads (1000A1-1000B4), with $k2 \leq 0.9$ and preferably $k2 \leq 0.8$.

8. The method according to any of the preceding claims, wherein the pads (1000A1-1000B4) have a height $H_{pad}$, and wherein two adjacent pads (1000A1-1000B4) are spaced apart by a distance D, such that:

$$H_{pad}/D < 2 \text{ and preferably } H_{pad}/D \leq 1.$$

9. The method according to any of the preceding claims, wherein the step of forming the pads (1000A1-1000B4) comprises etching the crystalline layer (300) and etching only a portion (220) of the creep layer (200) so as to keep a portion (210) of the creep layer (200) between the pads (1000A1-1000B4).

10. The method according to any of the preceding claims, wherein each pad (1000A1-1000B4) has an upper face (1001A1) and wherein epitaxially growing the crystallites (510A1-510B4) is at least partly and preferably solely carried out from said upper face (1001A1).

11. The method according to any of the preceding claims, comprising, after said formation of the pads (1000A1-1000B4), and before said epitaxial growth of the crystallites (510A1-510B4), a step of thinning the creep sections (220A1-220B4) by selective etching of the creep sections towards at least the crystalline sections (300A1-300B4).

12. The method according to any of the preceding claims, comprising a step of forming a barrier layer (740), preferably of AlGaN, on the nitride mesas (550A, 550B), and then a step of forming at least one source (760), one drain (770) and one gate (780) on the barrier layer (740) .

13. A method for forming a plurality of LEDs (570A, 570B) comprising at least the following successive steps:

    - forming a plurality of mesas (550A, 550B) each for forming an LED, the plurality of mesas (550A, 550B) being obtained by implementing the method according to any of claims 1 to 11,
    - making in the mesas (550A, 550B) of the plurality of mesas (550A, 550B) at least one of:

        o at least one pin junction,
        o at least one quantum well.

14. A microelectronic device comprising a substrate (100) having a plurality of mesas (550A, 550B) above it, each made of a nitride (N) preferably obtained from at least one of gallium (Ga), indium (In) and aluminium (Al), the device also comprising a plurality of pads (1000A-1000B4) extending between the substrate (100) and the plurality of mesas (550A, 550B), each mesa (550A, 550B) being entirely supported by a set (1000A, 1000B) of pads (1000A1-1000B4) from said plurality of pads (1000A1-1000B4) :

    each pad (1000A1-1000B4) comprises at least:

        - a first section, referred to as the creep section (220A1, 220B4), having a glass transition temperature $T_{glass\ transition}$,
        - a second section, referred to as the crystalline section (300A1, 300B4), formed by a crystalline material, the creep section (220A1, 220B4) and the crystalline section (300A1, 300B4) being successively arranged from the substrate (100),

    the material of the creep section (200A1-200B4) and said nitride being chosen so that:

$$T_{epitaxy} \geq k1 \times T_{glass\ transition}, \text{ with } k1=0.8,$$

$T_{epitaxy}$ being the minimum temperature allowing said nitride in which the mesas (550A, 550B) are made to be epitaxially formed.

15. An optoelectronic system comprising a microelectronic device according to the preceding claim, wherein at least some and preferably each mesa (550A, 550B) at least partly forms:

- a light-emitting diode (LED), or
- a transistor (554), preferably a high electron mobility transistor (HEMT).

500
300

FIG. 1A

10

550A    550B    550C
                  A      550D    550E

300

FIG. 1B

570A    520A    520B    570B
                                590
550A                            550B
                                300

Détail A    FIG. 1C

FIG. 2A

FIG. 2B

FIG. 2C

FIG. 2D

EP 3 987 574 B1

FIG. 3A

FIG. 3B

FIG. 3C

400
300
200
100

500
400
300
200
100

1000B4
500B4
400B4
300B4
220B4
210
100

1000B
1000B1
Hplot
110
W1

1000A
1000A4
dplot
Pplot
D

1000A1
500A1
400A1
300A1
220A1
210
100

z
y
x

35

FIG. 3D

FIG. 3E

FIG. 3F

FIG. 4A

100 μm

FIG. 4B

20 μm

FIG. 4C

2 μm

FIG. 4D

y

z x

510A1 510A2

α

560 561

510A1 510A2

FIG. 5A

y

z x

510A1 510A2

α

510A1 560 510A2

400A1, 300A1, 220A1

400A2, 300A2, 220A2

TA1

TA2

FIG. 5B

FIG. 5C

FIG. 5D

FIG. 6

**20 μm**

FIG. 7A

Figure 7b

**1 μm**

FIG. 7B

100

510

580

2 μm

FIG. 8A

510

2 μm

FIG. 8B

510

1 μm

1000   100

FIG. 8C

FIG. 9

FIG. 10

FIG. 11A

FIG. 11B

FIG. 12A

FIG. 12B

EP 3 987 574 B1

Z
y
x

700

2000

EP 3 987 574 B1

FIG. 12C

3300
3200
3100

3000

FIG. 12D

EP 3 987 574 B1

2100

2000

FIG. 12E

3400

3000

FIG. 12F

FIG. 12G

100

2000

3000

4000

FIG. 12H

200

550B

1000B1 - 1000B4

610

1000A1 - 1000A4

550A

FIG. 12I

553B
550B

4000

610

553A
550A

FIG. 12J

EP 3 987 574 B1

z
y
x

570A          620                    570B

552A          552A
              552B

               630

FIG. 12K

               620
               640

553A          630                    553B

FIG. 12L

z
y
x

552'A

650

552'A

552'B

552'B

FIG. 12M

800

FIG. 12N

553A

570A

570B

553B

FIG. 12O

740

550

400
300
200
100

FIG. 13A

740
551
550

400
300
200
100

FIG. 13B

750
740
730
720
710
551

550

400
300
200
100

FIG. 13C

554

760 780    770

554

770        780 760

554

760 780    770

740

550

400
300
200
100

FIG. 14A

554

554

911

554

910

FIG. 14B

FIG. 15A

FIG. 15B

FIG. 15C

554      554      554

760 780    770      770      780 760   760 780     770

740

550

930

FIG. 15D

760      760      760      760
780      780      780      780
770      770      770      770

740

554      $X_1$     $X_2$

FIG. 16A

760'

760
780
770

760
780
770

760
780
770

760
780
770

780'

740

770'

554          554

FIG. 16B

760
780
770
780
760

760
780
770
780
760

554

FIG. 17

1000A1
500A1
400A1
300A1
220A1
210
100

1000A

$d_{plot}$  1000A4

$H_{plot}$  110

1000B

1000B1

W1

$P_{plot}$

$d_{220A}$

$e_A$

1000B4
500B4
400B4
300B4
220B4
210
100

FIG. 18A

510A2    510A4

510A1    510A3    510B1    510B2    510B4
510B3

400A1
300A1
220A1

100

400B4
300B4
220B4

100

$d_{220A}$

FIG. 18B

FIG. 18C

EP 3 987 574 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2010109126 A1

**Littérature non-brevet citée dans la description**

- **CAO.** Electrical effect of plasma damage in p-GaN Induced by Reactive Ion Etching. *Appl. Phys. Lett.,* 1999, vol. 75, 2569
- **KODERA.** *Impact of Plasma damaged layer removal on GaN HEMT devices,* 2017
- **CHANG.** The Variation of Ohmic Contacts and Surface Characteristics. *J. of the Electrochemical Society,* 2002, vol. 149 (7
- Nanoheteroepitaxial growth of GaN on Si by organometallic vapor phase epitaxy. **ZUBIA D et al.** APPLIED PHYSICS LETTERS. AI P PUBLISHING LLC, 14 Février 2000, vol. 76, 858-860
- **J.P.HIRTH ; J. LOTHE.** Theory of dislocations. John Wiley and sons, 1982
- **C. E.DREYER ; A. JANOTTI ; C. G. VAN DE WALLE.** Absolute surface énergies of polar and nonpolar planes of GaN. *PHYSICAL REVIEW B,* 2014, vol. 89 (R), 081305
- **E.B YAKIMOV ; A.Y POLYAKOV.** Ebic investigation of dislocations in ELOG GaN. *Phys. Status Solidi,* 2015
- **SHIELDS.** Nanopendeo coalescence overgrowth of GaN on etched nanorod array. *Phys. Status Solidi C,* 2011, vol. 8 (7-8), 2334-2336